# EUROPEAN PATENT APPLICATION

(11) **EP 4 207 292 A1**
(43) Date of publication of application: **05.07.2023**
(21) Application number: 22217025.0
(22) Date of filing: 28.12.2022
(51) Int. Cl.: H01L 27/15

(54) **DISPLAY DEVICE**

(30) Priority: 31.12.2021 KR 20210193793
(71) Applicant: Samsung Display Co., Ltd., Yongin-si, Gyeonggi-do 17113 (KR)
(72) Inventor: SON, Sun Kwun, 17113 Yongin-si (KR); SHIN, Dong Hee, 17113 Yongin-si (KR); CHA, Na Hyeon, 17113 Yongin-si (KR); CHAI, Chong Chul, 17113 Yongin-Si (KR)
(74) Representative: Taor, Simon Edward William

(57) **Abstract**

A display device may include a display area including first to third areas, first and second signal lines in the display area, pixels connected to the first and second signal lines, a first pad area at one side of the second area, first lines in the second area and connected from the second area to the first pad area, and bridges in the display area and connecting second signal lines in the first area to the first lines. The first area may include first pixel columns including different second signal lines in the first area. The second area may include second pixel columns including different second signal lines in the second area and different first lines. Each of the second pixel columns may include a number of the first lines corresponding to a ratio of a number of the first pixel columns to a number of the second pixel columns.

## Description

### CROSS-REFERENCE TO RELATED APPLICATION

This application claims priority to and the benefit of Korean Patent Application No. 10-2021-0193793, filed on, December 31, 2021, in the Korean Intellectual Property Office (KIPO).

### BACKGROUND

### 1. Field

Embodiments of the present disclosure relate to a display device.

### 2. Description of the Related Art

Recently, interest in information display is increasing. Accordingly, research and development of a display device has been continuously conducted.

### SUMMARY

Aspects of one or more embodiments of the present disclosure are directed to a display device capable of reducing a non-display area.

Aspects and features of the present disclosure are not limited to the above-described aspects and features, and other technical aspects and features that are not described will be clearly understood by those skilled in the art from the following description.

According to one or more embodiments of the present disclosure, a display device may include a display area including a first area, a second area, and a third area in a first direction, first signal lines in the display area and extending in the first direction, second signal lines in the display area and extending in a second direction, pixels in the display area, the bridges connected to the first signal lines and the second signal lines, a first pad area at one side of the second area in the second direction, first lines in the second area and connected from the second area to the first pad area, and bridges in the display area and connecting second signal lines in the first area from among the second signal lines to the first lines. The first area may include first pixel columns including different second signal lines in the first area from among the second signal lines. The second area may include second pixel columns including different second signal lines in the second area from among the second signal lines and different first lines from among the first lines. Each of the second pixel columns may include a number of the first lines corresponding to a ratio of a number of the first pixel columns to a number of the second pixel columns.

In an embodiment, each of the second pixel columns may include the first lines corresponding to a number proportional to a number of the first pixel columns and a number of the second signal lines in each of the first pixel columns.

In an embodiment, each of the second pixel columns may include the number of the first lines inversely proportional to the number of the second pixel columns.

In an embodiment, each of the second pixel columns may include the same number of the first lines as a number of the second signal lines in each of the first pixel columns. The second area may include the same number of the second pixel columns as the number of the first pixel columns in the first area.

In an embodiment, each of the second pixel columns may include the number of the first lines corresponding to 1/K of a number of the second signal lines in each of the first pixel columns. K is a positive integer greater than or equal to 2. The second area may include the number of the second pixel columns corresponding to K times the number of the first pixel columns.

In an embodiment, a ratio of a number of the second signal lines in each of the first pixel columns to a number of the first lines in each of the second pixel columns may be N:M. Each of N and M is a positive integer greater than or equal to 2. A ratio of the number of the first pixel columns to the number of the second pixel columns may be M:N.

In an embodiment, the display device may further include a pad-free area at one side of the first area in the second direction.

In an embodiment, the first lines may extend in the second direction from the second area and are connected to the first pad area. The second signal lines in the second area from among the second signal lines may extend in the second direction from the second area and may be connected to the first pad area.

In an embodiment, the display device may further include first pads in the first pad area and electrically connected to the second signal lines in the first area through the first lines and the bridges, and second pads in the first pad area and electrically connected to the second signal lines in the second area.

In an embodiment, the display device may further include a second pad area at one side of the third area in the second direction. Second signal lines in the third area from among the second signal lines may extend in the second direction from the third area and may be connected to the second pad area.

In an embodiment, the display device may further include second lines in the third area, extending in the second direction from the third area, and connected to the second pad area. The second lines may be electrically connected to the first signal lines in the third area.

In an embodiment, the display device may further include third pads in the second pad area and electrically connected to the first signal lines through the second lines, and fourth pads in the second pad area and electrically connected to the second signal lines in the third area.

In an embodiment, the display device may further include a fourth area around the third area, and a third pad area at one side of the fourth area in the second direction.

In an embodiment, the display device may further include a power line in the display area and connected to the pixels, a third line in the fourth area, connected to the power line, extending in the second direction from the fourth area, and connected to the third pad area, fifth pads in the third pad area and electrically connected to the power line through the third line, and sixth pads in the third pad area and electrically connected to second signal lines in the fourth area from among the second signal lines.

In an embodiment, the display device may further include a dummy line extending in the second direction and connected to the power line in the display area.

In an embodiment, each of the first lines may be between pixel circuits of pixels in second pixel columns adjacent to each other in the first direction from among the second pixel columns, or around pixel circuits of pixels in a first or last second pixel column of the second area.

In an embodiment, the bridges may be between two pixel rows adjacent to each other in the second direction.

In an embodiment, the first area may be at both edges of the display area in the first direction. The second area may be directly adjacent to the first area in the first direction. The third area may be at a center of the display area in the first direction.

In an embodiment, the display device may further include a pad area including the first pad area and a second pad area adjacent to the first pad area and at one side of the third area in the second direction, and a pad-free area at both sides of the pad area in the first direction and at one side of the first area in the second direction.

According to an embodiment of the present disclosure, a display device may include a display panel including blocks arranged in a first direction, and driving circuits on pad areas of each of the blocks and arranged along the first direction. Each of the blocks may include a display area including a first area and a second area along the first direction, and including first signal lines extending in the first direction, second signal lines extending in a second direction, and pixels connected to the first signal lines and the second signal lines, a pad-free area and a pad area at one side of the first area and the second area in the second direction, respectively, first lines in the second area and connected from the second area to the pad area, and bridges connecting second signal lines in the first area from among the second signal lines to the first lines. The first area may include first pixel columns including different second signal lines in the first area from among the second signal lines. The second area may include second pixel columns including different second signal lines in the second area from among the second signal lines and different first lines from among the first lines. Each of the second pixel columns includes a number of the first lines corresponding to a ratio of a number of the first pixel columns to a number of the second pixel columns.

Details of one or more embodiments are included in the detailed description and drawings.

In accordance with the display device according to one or more embodiments of the present disclosure, lines may be uniformly formed in one direction between the display area and the pad area, and a length of the lines may be reduced or minimized. Accordingly, a non-display area of the display device may be reduced.

In one or more embodiments, the second signal lines of the first area positioned in each block of the display panel or an edge of the display panel may be connected (e.g., electrically connected) to each of the pads by connecting the second signal lines to first connection lines of an adjacent second area. Accordingly, the pad-free area corresponding to the first area may be secured, and a distance between driving circuits may be sufficiently secured.

In one or more embodiments, the number of first connection lines disposed in each second pixel column, and/or a width of the pad-free area may be appropriately adjusted, by adjusting the number and/or ratio of the second pixel columns of the second area allocated to the first pixel columns of the first area. Accordingly, the number of additional lines formed in each pixel column, a distance between driving circuits, and/or the like may be appropriately and/or easily adjusted according to a design condition and/or the like of the display device.

According to an aspect, there is provided a display device as set out in claim 1. Additional features are set out in claims 2 to 14. According to an aspect, there is provided a display device as set out in claim 15.

Features and aspects according to embodiments of the present disclosure are not limited by the contents described above, and various additional features and aspects are included in the present specification.

### BRIEF DESCRIPTION OF THE DRAWINGS

The above and other features and aspects of the present disclosure will become more apparent by describing in further detail embodiments thereof with reference to the accompanying drawings, in which:
FIG. 1 is a plan view illustrating a display device according to one or more embodiments of the present disclosure;
FIG. 2 is a circuit diagram illustrating a sub-pixel according to one or more embodiments of the present disclosure;
FIG. 3 is a plan view illustrating a display area according to one or more embodiments of the present disclosure;
FIG. 4 is a cross-sectional view schematically illustrating a display area according to one or more embodiments of the present disclosure;
FIG. 5 is a plan view illustrating a circuit unit of a display area according to one or more embodiments of the present disclosure;
FIGS. 6 to 8 are plan views illustrating a display panel according to embodiments of the present disclosure;
FIGS. 9 to 11 are plan views illustrating a display area according to embodiments of the present disclosure;
FIGS. 12 to 14 are plan views illustrating a connection structure between second signal lines of a first group, first connection lines, and first pads according to embodiments of the present disclosure;
FIG. 15 is a plan view illustrating a circuit unit of a first area according to one or more embodiments of the present disclosure;
FIGS. 16 and 17 are plan views illustrating a circuit unit of a second area according to embodiments of the present disclosure;
FIG. 18 is a plan view illustrating a circuit unit of a third area according to one or more embodiments of the present disclosure; and
FIG. 19 is a plan view illustrating a circuit unit of a fourth area according to one or more embodiments of the present disclosure.

### DETAILED DESCRIPTION

The present disclosure will now be described more fully with reference to the accompanying drawings in which embodiments of the disclosure are shown.

The terminology used herein is for the purpose of describing particular embodiments only and is not intended to limit the embodiments described herein.

The present disclosure may be modified in various ways and may have various forms, and specific embodiments will be illustrated in the drawings and described in more detail herein. In the following description, the singular forms also include the plural forms unless the context clearly includes the singular.

Meanwhile, embodiments of the present disclosure are not limited to the embodiments disclosed below, and it should be understood that the present disclosure includes all modifications, equivalents, and substitutes included in the scope of the present disclosure. In addition, each of the embodiments disclosed below may be implemented alone or in combination with at least one of other embodiments.

Throughout the drawings, the same reference numerals are used for configurations that are identical to or similar to each other, even though the configurations that are identical to or similar to each other are shown in different drawings. In describing embodiments of the present disclosure, redundant descriptions of configurations that are identical to or similar to each other will be omitted or simplified.

In describing embodiments of the present disclosure, the term "connection" may refer to a physical connection and an electrical connection inclusively. In one or more embodiments, "connection" may refer to a direct connection and an indirect connection inclusively, and may refer to an integral connection and a non-integral connection inclusively.

It will be further understood that the terms "includes," "including," "comprises," and/or "comprising," when used in this specification, specify the presence of stated features, steps, operations, elements, and/or components, but do not preclude the presence or addition of one or more other features, steps, operations, elements, components, and/or groups thereof.

As used herein, expressions such as "at least one of," "one of," and "selected from," when preceding a list of elements, modify the entire list of elements and do not modify the individual elements of the list.

As used herein, the term "and/or" includes any and all combinations of one or more of the associated listed items.

Further, the use of "may" when describing embodiments of the present disclosure refers to "one or more embodiments of the present disclosure."

It will be understood that when an element is referred to as being "on," "connected to," or "coupled to" another element, it may be directly on, connected, or coupled to the other element or one or more intervening elements may also be present. When an element is referred to as being "directly on," "directly connected to," or "directly coupled to" another element, there are no intervening elements present.

In the drawings, the relative sizes of elements, layers, and regions may be exaggerated and/or simplified for clarity. Spatially relative terms, such as "beneath," "below," "lower," "above," "upper," "bottom," "top," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

As used herein, the terms "substantially," "about," and similar terms are used as terms of approximation and not as terms of degree, and are intended to account for the inherent deviations in measured or calculated values that would be recognized by those of ordinary skill in the art.

Although the terms first, second, etc. may be used to describe various elements, these elements should not be limited by these terms. These terms are only used to distinguish one element from another element. For example, a first element may be referred to as a second element, and similarly, a second element may also be referred to as a first element without departing from the scope of the present disclosure.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

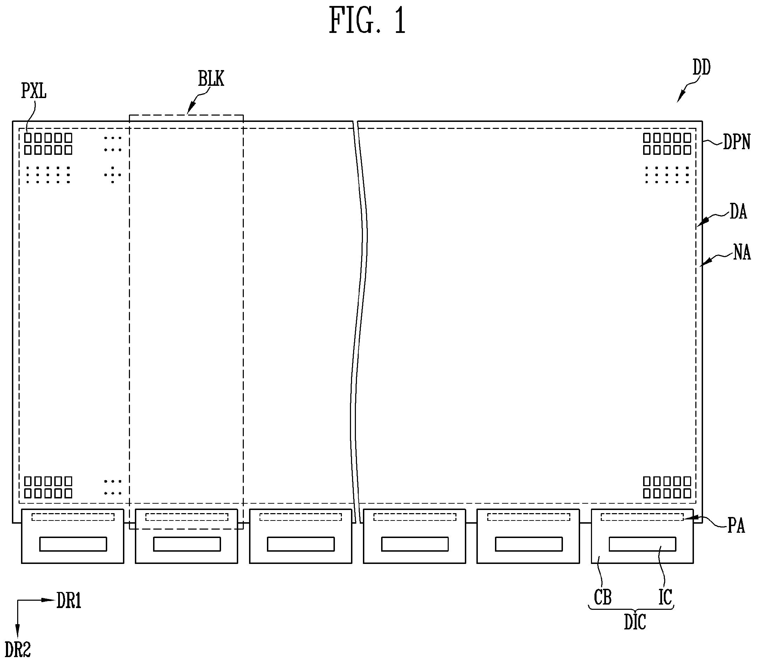

FIG. 1 is a plan view illustrating a display device DD according to one or more embodiments of the present disclosure.

Referring to FIG. 1, the display device DD may include a display panel DPN including pixels PXL and at least one driving circuit DIC connected to the display panel DPN. In one or more embodiments, the display device DD may include two or more driving circuits DIC.

The display panel DPN may include a display area DA in which the pixels PXL are disposed, and a non-display area NA positioned around the display area DA. Lines and/or pads connected (e.g., electrically connected) to the pixels PXL may be disposed in the non-display area NA. In one or more embodiments, the non-display area NA may be disposed at an edge of the display panel DPN and may surround the display area DA.

The pixels PXL may be arranged in the display area DA along at least one direction. For example, the pixels PXL may be regularly arranged in the display area DA along a first direction DR1 and a second direction DR2. In one or more embodiments, the first direction DR1 may be a horizontal direction or a transverse direction of the display area DA, and the second direction DR2 may be a vertical direction or a longitudinal direction of the display area DA.

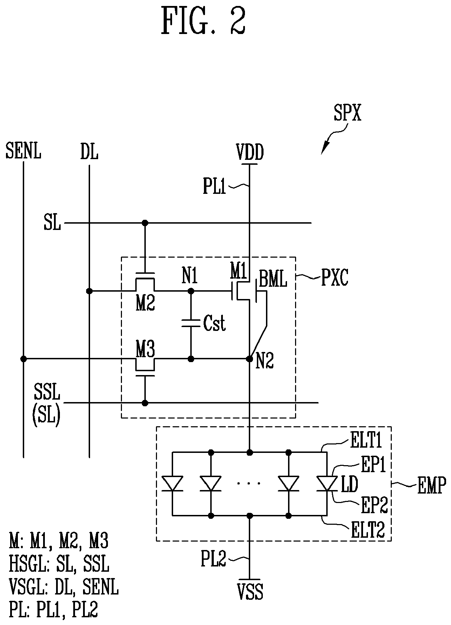

Each pixel PXL may include a sub-pixel (e.g., a sub-pixel SPX of FIG. 2). For example, each pixel PXL may include sub-pixels SPX emitting light of different colors.

The driving circuit DIC (e.g., a driving integrated circuit) may be disposed on a pad area PA of the display panel DPN and may be connected (e.g., electrically connected) to pads provided in the pad area PA. The driving circuit DIC may supply driving signals to the display panel DPN through the pads.

The driving circuit DIC may include a circuit board CB and an integrated circuit IC. The circuit board CB may be a flexible printed circuit board (FPCB), a polymer film, or another type of substrate or film. In one or more embodiments, the driving circuit DIC may be attached on the pad area PA in a form of a tape automated bonding (TAB)-IC. The TAB-IC may include a tape carrier package (TCP) in which a chip-type integrated circuit IC is mounted on a polymer film, and a chip-on film (COF) in which a chip-type integrated circuit IC is mounted on an FPCB. The driving circuit DIC may be provided in another form or structure.

The integrated circuit IC may include drivers for driving the pixels PXL. For example, the driving circuit DIC may include scan driver (also referred to as a "gate driver") for supplying respective scan signals and/or control signals to scan lines and/or control lines of the pixels PXL (e.g., the sub-pixels SPX configuring the pixels PXL), and a data driver (also referred to as a "source driver") for supplying respective data signals to data lines of the pixels PXL. In one or more embodiments, the data driver may include a sensing circuit for sensing a characteristic of the pixels PXL. In one or more embodiments, the display device DD may include a separate sensing circuit that is separate from the data driver.

In one or more embodiments, the display panel DPN may be partitioned into two or more blocks (or sub-areas) BLK, and the display device DD may include two or more driving circuits DIC corresponding to the blocks BLK. For example, the display panel DPN may include the blocks BLK disposed along the first direction DR1, and the display device DD may include the driving circuits DIC disposed along the first direction DR1 on the pad areas PA of the display panel DPN to correspond to the respective blocks BLK. The respective driving circuits DIC may be connected (e.g., electrically connected) to the pixels PXL positioned in the corresponding block BLK and may supply driving signals to the pixels PXL.

The display device DD may further include an additional driving element. For example, the display device DD may further include a timing controller connected (e.g., electrically connected) to the integrated circuits IC, and a power voltage generator connected (e.g., electrically connected) to the pixels PXL and the integrated circuits IC. In one or more embodiments, the timing controller and the power voltage generator may be mounted and/or formed on a separate circuit board connected (e.g., electrically connected) to the driving circuits DIC, but embodiments of the present disclosure are not limited thereto.

In one or more embodiments, the driving circuits DIC may be disposed only on one edge area of the display panel DPN to be adjacent to any one side of the display area DA. For example, the driving circuits DIC may be disposed only on a portion (e.g., a portion corresponding to the pad areas PA and an area around the pad areas PA) of the non-display area NA corresponding to a lower edge area or an upper edge area of the display panel DPN. In this case, the display device DD may be a single side driving display device supplying driving signals to the display panel DPN through pads disposed in the lower edge area or the upper edge area of the display panel DPN and the driving circuits DIC connected (e.g., electrically connected) to the pads. In a case of the single side driving display device, the driving circuits DIC and/or pads for connection to the driving circuits DIC may not be disposed on remaining areas (e.g., the upper edge area, a left edge area, and a right edge area of the display panel DPN) which are in contact with other sides of the display area DA among the non-display area NA of the display panel DPN. Accordingly, in the remaining areas of the non-display area NA, a width and/or an area of the non-display area NA may be reduced or minimized.

FIG. 2 is a circuit diagram illustrating a sub-pixel SPX according to one or more embodiments of the present disclosure. For example, FIG. 2 illustrates one sub-pixel SPX that may be included in the pixel PXL of FIG. 1. In one or more embodiments, the sub-pixels SPX included in each pixel PXL may have circuit configurations that are substantially identical to or similar to each other. In one or more embodiments, the pixels PXL disposed in the display area DA may be configured to be substantially identical to or similar to each other.

Referring to FIGS. 1 and 2, the sub-pixel SPX may be connected to signal lines to which driving signals are supplied. For example, the sub-pixel SPX may be connected (e.g., electrically connected) to at least one first signal line HSGL and at least one second signal line VSGL.

The first signal line HSGL may be a signal line (e.g., a horizontal signal line) extending in the first direction DR1 in the display area DA and at least two sub-pixels SPX disposed in the same pixel row along the first direction DR1 may be commonly connected to the same first signal line HSGL. The first signal line HSGL may include a scan line SL. In one or more embodiments, the first signal line HSGL may include a separate control line SSL separated from the scan line SL. In one or more embodiments, the control line SSL may be integrated with the scan line SL.

The second signal line VSGL may be a signal line (e.g., a vertical signal line) extending in the second direction DR2 in the display area DA, and at least two sub-pixels SPX disposed in the same pixel column along the second direction DR2 may be commonly connected to the same second signal line VSGL. The second signal line VSGL may include a data line DL (e.g., a sub-data line corresponding to the corresponding sub pixel SPX). In one or more embodiments, the second signal line VSGL may further include a separate sensing line SENL (or an initialization power line) separated from the data line DL. The sensing line SENL may be connected to initialization power (or reference power) or a sensing circuit corresponding to a display period or a sensing period.

The sub-pixel SPX may also be connected to power lines PL including a first power line PL1 and a second power line PL2 to which power voltages are supplied. For example, the sub-pixel SPX may be connected (e.g., electrically connected) to the first power line PL1 to which a first power voltage VDD is supplied and the second power line PL2 to which a second power voltage VSS is supplied.

The sub-pixel SPX may include a light emitting unit EMP for generating light of a luminance corresponding to each data signal. The sub-pixel SPX may further include a pixel circuit PXC for driving the light emitting unit EMP.

The pixel circuit PXC may be connected to the scan line SL and the data line DL, and may be connected between the first power line PL1 and the light emitting unit EMP. For example, the pixel circuit PXC may be connected (e.g., electrically connected) to the scan line SL to which a first scan signal is supplied, the data line DL to which the data signal is supplied, the first power line PL1 to which the first power voltage VDD is supplied, and a first electrode ELT1 of the light emitting unit EMP.

The pixel circuit PXC may include at least one transistor M (e.g., a first transistor M1, a second transistor M2, or a third transistor M3) and a capacitor Cst. For example, the pixel circuit PXC may include a first transistor M1, a second transistor M2, a third transistor M3, and the capacitor Cst.

The first transistor M1 may be connected between the first power line PL1 and a second node N2. The second node N2 may be a node to which the pixel circuit PXC and the light emitting unit EMP are connected to each other. For example, the second node N2 may be a node to which one electrode (e.g., a source electrode) of the first transistor M1 and the first electrode ELT1 (e.g., an anode electrode) of the light emitting unit EMP are connected. A gate electrode of the first transistor M1 may be connected to a first node N1. The first transistor M1 may control a driving current supplied to the light emitting unit EMP in response to a voltage of the first node N1. For example, the first transistor M1 may be a driving transistor of the sub-pixel SPX.

In one or more embodiments, the first transistor M1 may further include a bottom metal layer BML (e.g., a back gate electrode). In one or more embodiments, the bottom metal layer BML may be connected to the one electrode (e.g., the source electrode) of the first transistor M1.

In one or more embodiments in which the first transistor M1 includes the bottom metal layer BML, a back-biasing technique (or a sync technique) for moving a threshold voltage of the first transistor M1 in a negative direction or a positive direction by applying a back-biasing voltage to the bottom metal layer BML of the first transistor M1 may be applied. In one or more embodiments, when the bottom metal layer BML is disposed under a semiconductor pattern configuring a channel of the first transistor M1, an operation characteristic of the first transistor M1 may be stabilized by blocking light incident on the semiconductor pattern.

The second transistor M2 may be connected between the data line DL and the first node N1. A gate electrode of the second transistor M2 may be connected to the scan line SL. The second transistor M2 may be turned on when the first scan signal of a gate-on voltage (e.g., a high level voltage) is supplied from the scan line SL, to connect the data line DL and the first node N1.

For each frame period, a data signal of a corresponding frame may be supplied to the data line DL. The data signal may be transmitted to the first node N1 through the second transistor M2 during a period in which the first scan signal of the gate-on voltage is supplied. For example, the second transistor M2 may be a switching transistor for transmitting each data signal into the sub-pixel SPX.

One electrode of the capacitor Cst may be connected to the first node N1 and another electrode of the capacitor Cst may be connected to the second node N2. The capacitor Cst may be charged with a voltage corresponding to the data signal supplied to the first node N1 during each frame period.

The third transistor M3 may be connected between the second node N2 and the sensing line SENL. A gate electrode of the third transistor M3 may be connected to the control line SSL (or the scan line SL). The third transistor M3 may be turned on when a second scan signal (or the first scan signal) of a gate-on voltage (e.g., a high level voltage) is supplied from the control line SSL, to transmit an initialization power voltage (or a reference power voltage) supplied to the sensing line SENL to the second node N2 or transmit a voltage of the second node N2 to the sensing line SENL. The voltage of the second node N2 transmitted to the sensing circuit through the sensing line SENL may be provided to a controller, and may be used to compensate for a characteristic deviation of the pixels PXL (e.g., the sub-pixels SPX).

In FIG. 2, all of the transistors M included in the pixel circuit PXC are N-type transistors, but embodiments of the present disclosure are not limited thereto. For example, at least one of the first, second, and third transistors M1, M2, and M3 may be a P-type transistor. In addition, a structure and a driving method of the sub-pixel SPX may be variously changed in any suitable manner according to embodiments.

The light emitting unit EMP may include the first electrode ELT1 (also referred to as a "first pixel electrode"), a second electrode ELT2 (also referred to as a "second pixel electrode"), and at least one light emitting element LD connected between the first power line PL1 and the second power line PL2. For example, the light emitting unit EMP may include the first electrode ELT1 connected (e.g., electrically connected) to the first power line PL1 through the pixel circuit PXC, the second electrode ELT2 connected (e.g., electrically connected) to the second power line PL2 through the pixel circuit PXC, and at least one light emitting element LD connected (e.g., electrically connected) between the first electrode ELT1 and the second electrode ELT2.

The first power voltage VDD and the second power voltage VSS may have different voltage levels. For example, the first power voltage VDD may be a power voltage of a high level, and the second power voltage VSS may be a power voltage of a low level.

In one or more embodiments, the light emitting unit EMP may include light emitting elements LD connected in parallel in a forward direction between the first electrode ELT1 and the second electrode ELT2. The light emitting elements LD may include first ends EP1 (e.g., P-type ends) connected to the first electrode ELT1 and second ends EP2 (e.g., N-type ends) connected to the second electrode ELT2.

In one or more embodiments, the sub-pixel SPX may include light emitting elements LD connected only in series between the first electrode ELT1 and the second electrode ELT2 or may include only a single light emitting element LD connected in the forward direction between the first electrode ELT1 and the second electrode ELT2. In one or more embodiments, the light emitting unit EMP may include light emitting elements LD connected in series and/or in parallel between the first electrode ELT1 and the second electrode ELT2. For example, a structure of the light emitting unit EMP may be variously changed in any suitable manner according to embodiments.

A type, a structure, a shape, a size, and/or the number of the light emitting elements LD provided in the light emitting unit EMP may be changed according to embodiments. For example, each light emitting element LD may be an organic light emitting diode or an inorganic light emitting diode. In one or more embodiments, each light emitting element LD may be manufactured in various suitable structures, shapes and/or sizes, and a single light emitting element LD may be provided or a plurality of light emitting elements LD may be provided in each light emitting unit EMP.

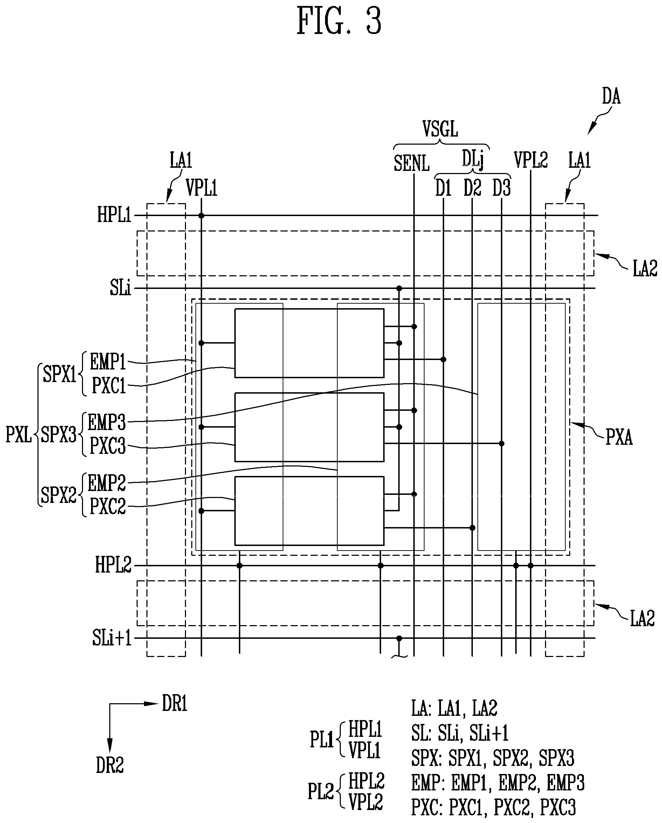

FIG. 3 is a plan view illustrating a display area DA according to one or more embodiments of the present disclosure. FIG. 3 schematically shows a structure of the display area DA based on a pixel area PXA in which one pixel PXL is disposed.

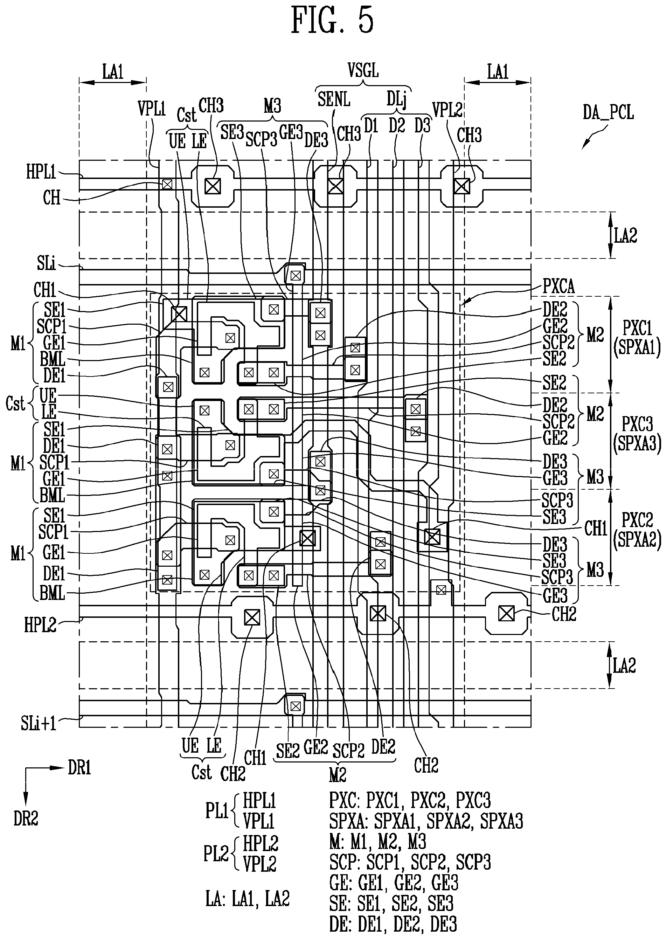

The pixel area PXA may include an area (e.g., a pixel circuit area PXCA of FIG. 5) in which the pixel circuits PXC of the sub-pixels SPX configuring the corresponding pixel PXL are disposed, and an area in which the light emitting units EMP of the sub-pixels SPX are disposed. The sub-pixels SPX may include a first sub-pixel SPX1, a second sub-pixel SPX2, and a third sub-pixel SPX3 in the pixel area PXA. In one or more embodiments, the pixel area PXA may further include portions of lines positioned around the corresponding pixel PXL. For example, at least a portion of the lines positioned around the pixels PXL may pass through the pixel area PXA in which the pixels PXL are disposed. FIG. 3 shows a pixel PXL disposed on an i-th (i is a natural number) horizontal line (e.g., an i-th pixel row) and a j-th (j is a natural number) vertical line (e.g., a j-th pixel column) of the display area DA, and portions of lines disposed around the pixel PXL.

Referring to FIGS. 1 to 3, the display area DA may include the pixels PXL and lines connected to the pixels PXL. The lines may include the first signal lines HSGL (e.g., the scan lines SL), the second signal lines VSGL (e.g., the data lines DL and the sensing lines SENL), and the power lines PL (e.g., the first power line PL1 and the second power line PL2). In one or more embodiments, the control line SSL of each horizontal line may be integrated with the scan line SL of a corresponding horizontal line.

The scan lines SL may extend along the first direction DR1 in the display area DA and may be formed for each vertical line. For example, an i-th scan line SLi may be disposed on an i-th horizontal line of the display area DA, and an (i+1)-th scan line SLi+1 may be disposed on an (i+1)-th horizontal line of the display area DA. Each scan line SL may be connected to the pixel circuits PXC of the sub-pixels SPX disposed on the corresponding horizontal line.

The data lines DL may extend along the second direction DR2 in the display area DA, and may be formed for each vertical line. For example, a j-th data line DLj may be disposed on a j-th vertical line of the display area DA. However, embodiments of the present disclosure are not limited thereto. For example, the data lines DL may be formed for at least two adjacent vertical lines, and the at least two vertical lines may share the data lines DL. In this case, a time period during which the data signal is input to the pixels PXL may be divided, by separating the scan lines SL connected to the pixels PXL of the at least two vertical lines.

Each data line DL may be connected to the pixel circuits PXC of the sub-pixels SPX disposed on the corresponding vertical line. In one or more embodiments, each data line DL may include sub-data lines individually connected to the sub-pixels SPX configuring each pixel PXL. For example, the j-th data line DLj may include a first sub-data line D1 connected to first sub-pixels SPX1 of the pixels PXL disposed on the j-th vertical line, a second sub-data line D2 connected to second sub-pixels SPX2 of the pixels PXL disposed on the j-th vertical line, and a third sub-data line D3 connected to third sub-pixels SPX3 of the pixels PXL disposed on the j-th vertical line. Accordingly, the data signal may be individually supplied to each sub-pixel SPX.

The sensing lines SENL may extend along the second direction DR2 in the display area DA, and may be formed for at least one vertical line. In one or more embodiments, the sensing lines SENL may be formed for each vertical line and may be commonly connected to the sub-pixels SPX configuring each pixel PXL. In this case, characteristics of each pixel PXL may be individually detected. In one or more embodiments, the pixels PXL formed on at least two vertical lines may share one sensing line SENL, and the characteristics of the pixels PXL may be detected in pixel group unit including the pixels PXL.

The first power line PL1 and the second power line PL2 may be commonly connected to the pixels PXL of the display area DA. For example, the first power line PL1 may be commonly connected to the pixel circuits PXC of the sub-pixels SPX, and the second power line PL2 may be commonly connected to the light emitting units EMP of the sub-pixels SPX.

In one or more embodiments, each of the first power line PL1 and the second power line PL2 may be formed in a mesh shape. Accordingly, a voltage drop (IR drop) of the first power voltage VDD and the second power voltage VSS may be prevented, reduced, or minimized, and the first power voltage VDD and the second power voltage VSS of a uniform level may be transmitted to the pixels PXL.

For example, the first power line PL1 may include a first horizontal power line HPL1 extending in the first direction DR1 in the display area DA, and a first vertical power line VPL1 extending in the second direction DR2 in the display area DA and connected to the first horizontal power line HPL1. In one or more embodiments, a plurality of first horizontal power lines HPL1 and first vertical power lines VPL1 may be disposed in the display area DA. The first horizontal power lines HPL1 and the first vertical power lines VPL1 may cross each other and may be connected to each other at all cross points or some of the cross points.

Similarly, the second power line PL2 may include a second horizontal power line HPL2 extending in the first direction DR1 in the display area DA and a second vertical power line VPL2 extending in the second direction DR2 in the display area DA and connected to the second horizontal power line HPL2. In one or more embodiments, a plurality of second horizontal power lines HPL2 and second vertical power lines VPL2 may be disposed in the display area DA. The second horizontal power lines HPL2 and the second vertical power lines VPL2 may cross each other and may be connected to each other at all cross points or some of the cross points.

In one or more embodiments, the first horizontal power line HPL1 and the second horizontal power line HPL2 may be formed for each one horizontal line or at least two horizontal lines. For example, the first horizontal power line HPL1 and the second horizontal power line HPL2 may be arranged alternately in the display area DA along the second direction DR2 with the pixels PXL, which are disposed on each horizontal line, interposed therebetween. For example, the first horizontal power lines HPL1 may be formed for each odd-numbered horizontal line, and the second horizontal power lines HPL2 may be formed for each evennumbered horizontal line. The first horizontal power line HPL1 and the second horizontal power line HPL2 adjacent to each other may be spaced from each other with the pixel circuits PXC, which are arranged in the pixel row of each horizontal line, interposed therebetween.

In one or more embodiments, the first vertical power line VPL1 and the second vertical power line VPL2 may be formed for each at least one vertical line. For example, the first vertical power line VPL1 and the second vertical power line VPL2 may be formed for each vertical line, and may be spaced from each other with the pixels circuits PXC, which are arranged in the pixel column of the corresponding vertical line, interposed therebetween. A structure, the number, a position, and/or the like of the power lines PL may be variously changed in any suitable manner according to embodiments.

Each pixel PXL may include the sub-pixels SPX. For example, each pixel PXL may include the first sub-pixel SPX1, the second sub-pixel SPX2, and the third sub-pixel SPX3.

Each sub-pixel SPX may include a pixel circuit PXC and a light emitting unit EMP. For example, the first sub-pixel SPX1 may include a first pixel circuit PXC1 and a first light emitting unit EMP1, the second sub-pixel SPX2 may include a second pixel circuit PXC2 and a second light emitting unit EMP2, and the third sub-pixel SPX3 may include a third pixel circuit PXC3 and a third light emitting unit EMP3.

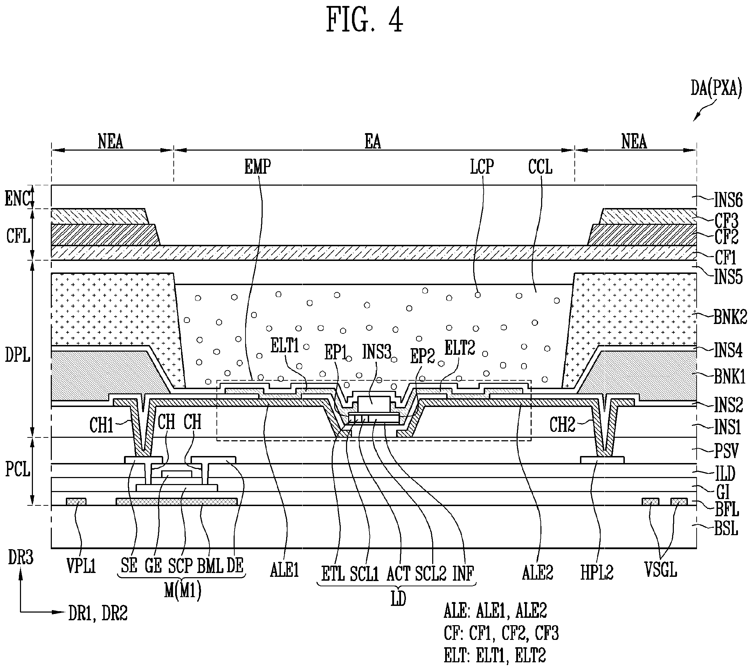

In one or more embodiments, the pixel circuits PXC and the light emitting units EMP of each pixel PXL may be disposed on or at different layers and may overlap each other. For example, the pixel circuits PXC may be disposed in a circuit unit (e.g., a circuit unit PCL of FIG. 4) (also referred to as a "pixel circuit unit" or a "circuit layer") of the pixel area PXA in which each pixel PXL is disposed. The light emitting units EMP may be disposed in a display unit (e.g., a display unit DPL of FIG. 4) (also referred to as a "light source unit" or a "display layer") of each pixel area PXA to overlap the pixel circuits PXC of the corresponding pixel PXL, and/or at least one line (e.g., the scan line SL, the sensing line SENL, the data line DL (e.g., the sub-data line), the first power line PL1, and/or the second power line PL2).

The first, second, and third pixel circuits PXC1, PXC2, and PXC3 may be arranged in each pixel area PXA along the second direction DR2. For example, the first, second, and third pixel circuits PXC1, PXC2, and PXC3 of the pixel PXL may be arranged along the second direction DR2 in a suitable order (e.g., a predetermined order) in the pixel area PXA in which the pixel PXL is provided.

In one or more embodiments, the third pixel circuit PXC3 may be positioned at a center of each pixel area PXA in the second direction DR2, and the first and second pixel circuits PXC1 and PXC2 may be disposed on or at opposite sides of the third pixel circuit PXC3 in the second direction DR2. Positions and/or an arrangement order of the first, second, and third pixel circuits PXC1, PXC2, and PXC3 may be changed according to embodiments.

The first, second, and third pixel circuits PXC1, PXC2, and PXC3 may be commonly connected to the first power line PL1 and the scan line SL (e.g., the i-th scan line SLi) of the corresponding horizontal line and may be connected to different sub-data lines of the corresponding vertical line. For example, the first pixel circuit PXC1 may be connected to the first sub-data line D1, the second pixel circuit PXC2 may be connected to the second sub-data line D2, and the third pixel circuit PXC3 may be connected to the third sub-data line D3.

In one or more embodiments, the first, second, and third pixel circuits PXC1, PXC2, and PXC3 may be further connected to the sensing line SENL. For example, the first, second, and third pixel circuits PXC1, PXC2, and PXC3 may be commonly connected to the sensing line SENL formed on the corresponding vertical line.

The first, second, and third light emitting units EMP1, EMP2, and EMP3 may be connected between each pixel circuit PXC and the second power line PL2. For example, the first, second, and third light emitting units EMP1, EMP2, and EMP3 may be connected to the first, second, and third pixel circuits PXC1, PXC2, and PXC3 through each first contact hole (e.g., the first contact hole CH1 of FIGS. 4 and 5), respectively. In one or more embodiments, the first, second, and third light emitting units EMP1, EMP2, and EMP3 may be connected to the adjacent second horizontal power line HPL2 through each second contact hole (e.g., the second contact hole CH2 of FIGS. 4 and 5).

The first, second, and third light emitting units EMP1, EMP2, and EMP3 may be arranged along the first direction DR1 in each pixel area PXA. For example, the first, second, and third light emitting units EMP1, EMP2, and EMP3 may be sequentially arranged along the first direction DR1 in the pixel area PXA in which the corresponding pixel PXL is provided.

The first, second, and third light emitting units EMP1, EMP2, and EMP3 may overlap or may not overlap at least one line (e.g., the scan line SL, the data line DL, the sensing line SENL, the first power line PL1 and/or the second power line PL2). Positions and/or an arrangement order of the first, second, and third light emitting units EMP1, EMP2, and EMP3 may be changed according to embodiments.

In the embodiment of FIG. 3, the pixel circuits PXC and the light emitting units EMP of the sub-pixels SPX are arranged along different directions in the pixel area PXA in which each pixel PXL is provided, but embodiments of the present disclosure is not limited thereto. For example, positions, an arrangement direction, overlap-or-not, and/or the like of the pixel circuits PXC and the light emitting units EMP may be variously changed in any suitable manner according to embodiments.

A line space (or a line area) LA in which additional lines may be disposed may be provided in a periphery of each pixel area PXA and/or in a portion thereof. For example, in the circuit unit PCL in which the pixel circuits PXC and lines are disposed, first line spaces LA1 may be provided on left and right sides of each pixel area PXA, and second line spaces LA2 may be provided above and below each pixel area PXA.

In one or more embodiments, each first line space LA1 may be a vertical line space extending in the second direction DR2 in the display area DA. For example, each first line space LA1 may be positioned around the pixel circuits PXC disposed in a first pixel column or a last pixel column of the display area DA, or may be disposed between the pixel circuits PXC of two adjacent pixel columns in the display area DA, and may extend in the second direction DR2.

In one or more embodiments, each second line space LA2 may be a horizontal line space extending in the first direction DR1 in the display area DA. For example, each of the second line spaces LA2 may be positioned around the pixel circuits PXC disposed in the first pixel row or the last pixel row of the display area DA, or may be positioned between the pixel circuits PXC of two adjacent pixel rows in the display area DA, and may extend in the first direction DR1.

The additional lines may be provided in the line spaces LA. For example, connection lines, bridges, and/or dummy lines may be provided in the line spaces LA. A more detailed description thereof is provided below.

FIG. 4 is a cross-sectional view schematically illustrating a display area DA according to one or more embodiments of the present disclosure. For example, FIG. 4 schematically illustrates a cross-section of one pixel area PXA based on one sub-pixel SPX.

Referring to FIGS. 1 to 4, the display panel DPN including the display area DA may include a base layer BSL, the circuit unit (or the circuit layer) PCL, and the display unit (or the display layer) DPL. The circuit unit PCL and the display unit DPL may be provided to overlap each other on the base layer BSL. For example, the circuit unit PCL and the display unit DPL may be sequentially disposed on one surface of the base layer BSL.

The display device DD may further include a color filter unit (or a color filter layer) CFL and/or an encapsulation unit (or an encapsulation layer) ENC disposed on the display unit DPL. In one or more embodiments, the color filter unit CFL and/or the encapsulation unit ENC may be directly formed on one surface of the base layer BSL on which the circuit unit PCL and the display unit DPL are formed, but embodiments of the present disclosure are not limited thereto.

The base layer BSL may be a member for forming the display panel DPN, and may be a substrate or a film of a rigid or flexible material. The base layer BSL may have a single layer or multilayer structure, and a material thereof is not particularly limited in embodiments.

The circuit unit PCL may be provided on one surface of the base layer BSL.

The circuit unit PCL may include circuit elements configuring each pixel circuit PXC. For example, in each pixel area PXA of the circuit unit PCL, the circuit elements (e.g., the transistors M and the capacitor Cst) configuring the pixel circuits PXC of the corresponding pixel PXL may be formed. FIG. 4 shows any one transistor (e.g., the first transistor including M1 and the bottom metal layer BML) provided in each pixel circuit PXC as an example of the circuit elements that may be disposed in the circuit unit PCL.

The circuit unit PCL may further include the lines connected to the pixels PXL. For example, the circuit unit PCL may include the scan lines SL, the control lines SSL, the data lines DL, the sensing lines SENL, the first power line PL1 and/or the second power line PL2 connected to the pixels PXL. FIG. 4 schematically shows the first vertical power line VPL1 and the second signal line VSGL (e.g., the data line DL and the sensing line SENL) positioned on or at the same layer (e.g., a first conductive layer) as the bottom metal layer BML, and the second horizontal power line HPL2 positioned on or at the same layer (e.g., a third conductive layer) as a source electrode SE and a drain electrode DE of the transistor M, as an example of the lines that may be disposed in the circuit unit PCL.

The circuit unit PCL may further include insulating layers. For example, the circuit unit PCL may include a buffer layer BFL, a gate insulating layer GI, an interlayer insulating layer ILD, and/or a passivation layer PSV sequentially disposed on one surface of the base layer BSL.

The circuit unit PCL may include the first conductive layer disposed on the base layer BSL and including the bottom metal layer BML of the first transistor M1. For example, the first conductive layer may be disposed between the base layer BSL and the buffer layer BFL, and may include the bottom metal layer BML of the first transistor M1 provided in each pixel circuit PXC. The bottom metal layer BML of the first transistor M1 may overlap a gate electrode GE and a semiconductor pattern SCP of the first transistor M1.

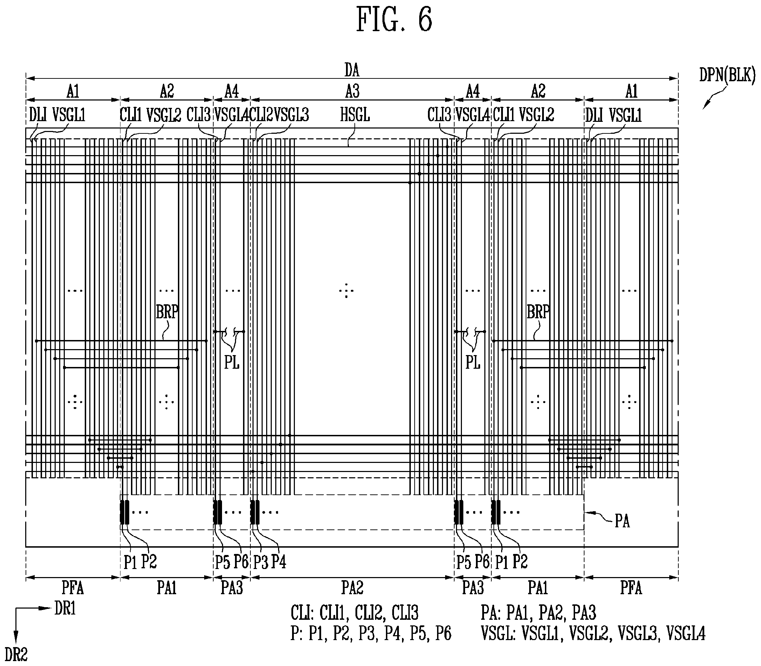

The first conductive layer may further include lines. For example, the first conductive layer may include at least some of the lines (e.g., portions of the lines) extending in the second direction DR2 in the display area DA. For example, the first conductive layer may include the first vertical power lines VPL1, the second signal lines VSGL, and second vertical power lines VPL2. In one or more embodiments, the first conductive layer may include additional lines (e.g., first connection lines CLI1, second connection lines CLI2, third connection lines CLI3, and/or dummy lines DLI of FIGS. 6 to 8) extending in the second direction DR2 in the display area DA and disposed in each of the first line spaces LA1.

The buffer layer BFL may be disposed on one surface of the base layer BSL including the first conductive layer. The buffer layer BFL may prevent or substantially prevent an impurity from diffusing into each circuit element.

A semiconductor layer may be disposed on the buffer layer BFL. The semiconductor layer may include the semiconductor pattern SCP of each transistor M. The semiconductor pattern SCP may include a channel region overlapping the gate electrode GE of the corresponding transistor M, and first and second conductive regions (e.g., source and drain regions) disposed on or at opposite sides of the channel region.

The gate insulating layer GI may be disposed on the semiconductor layer. A second conductive layer may be disposed on the gate insulating layer GI.

The second conductive layer may include the gate electrode GE of each transistor M. In one or more embodiments, the second conductive layer may further include the one electrode of the capacitor Cst, a bridge pattern, and/or the like provided in the pixel circuit PXC. Additionally, when at least one line disposed in the display area DA is configured of multiple layers, the second conductive layer may further include a conductive pattern configuring the at least one line.

The interlayer insulating layer ILD may be disposed on the second conductive layer. The third conductive layer may be disposed on the interlayer insulating layer ILD.

The third conductive layer may include the source electrode SE and the drain electrode DE of each transistor M. The source electrode SE and the drain electrode DE may be connected to different regions (e.g., the source region and the drain region, respectively) of the semiconductor pattern SCP included in the corresponding transistor M through respective contact holes CH.

The third conductive layer may further include the electrode of the capacitor Cst, lines, a bridge pattern, and/or the like provided in the pixel circuit PXC. For example, the third conductive layer may include at least some lines (e.g., portions of the lines) extending in the first direction DR1 in the display area DA. For example, the third conductive layer may include the first signal lines HSGL (e.g., the scan lines SL), the first horizontal power lines HPL1, and the second horizontal power lines HPL2. In one or more embodiments, the third conductive layer may further include additional lines, conductive patterns, and/or bridges (e.g., bridges BRP of FIGS. 6 to 8) extending in the first direction DR1 in the display area DA and disposed in each of the second line spaces LA2.

Each electrode, line, conductive pattern, and/or bridge configuring the first to third conductive layers may have conductivity (e.g., may be conductive) by including a conductive material, and a configuration material thereof is not particularly limited in embodiments. For example, each conductive pattern, electrode, and/or line configuring the first to third conductive layers may include at least one metal selected from among molybdenum (Mo), aluminum (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), or other conductive materials.

The passivation layer PSV may be disposed on the third conductive layer. Each of the buffer layer BFL, the gate insulating layer GI, the interlayer insulating layer ILD, and the passivation layer PSV may be a single layer or multiple layers, and may include an inorganic insulating material and/or an organic insulating material. In one or more embodiments, each of the buffer layer BFL, the gate insulating layer GI, and the interlayer insulating layer ILD may include various suitable types of inorganic insulating materials including silicon nitride (SiNₓ), silicon oxide (SiOₓ), or silicon oxynitride (SiOₓN_{y}). In one or more embodiments, the passivation layer PSV may include an organic insulating layer, and may be disposed (e.g., entirely disposed) in the display area DA to planarize a surface of the circuit unit PCL. In one or more embodiments, the passivation layer PSV may be multiple layers including an inorganic insulating layer and an organic insulating layer.

The display unit DPL may be disposed on the passivation layer PSV.

The display unit DPL may include the light emitting unit EMP of each pixel PXL. For example, the display unit DPL may include alignment electrodes ALE, at least one light emitting element LD, and pixel electrodes ELT disposed in the emission area EA of each pixel PXL. In one or more embodiments, each light emitting unit EMP may include at least two light emitting elements LD.

In one or more embodiments, the display unit DPL may further include insulating patterns and/or insulating layers sequentially disposed on one surface of the base layer BSL on which the circuit unit PCL is formed. For example, the display unit DPL may include a first insulating layer (or a bank pattern) INS1, a second insulating layer INS2, a first bank BNK1, a third insulating layer INS3, and a fourth insulating layer INS4. In one or more embodiments, the display unit DPL may further include a second bank BNK2, a light conversion layer CCL, and/or a fifth insulating layer INS5.

The first insulating layer INS1 may be disposed on the passivation layer PSV and may overlap a portion of each of the alignment electrodes ALE. The first insulating layer INS1 may have an opening or a recess corresponding to a light emitting element arrangement area (e.g., an area in which the light emitting elements LD are arranged) positioned in the emission area EA of each sub-pixel SPX. For example, the first insulating layer INS1 may surround the area in which the light emitting elements LD are disposed so as to surround the light emitting elements LD disposed in the emission area EA of each sub-pixel SPX, may be disposed under the alignment electrodes ALE to overlap a portion of each of the alignment electrodes ALE. In one or more embodiments, the first insulating layer INS1 may be formed of separate insulating patterns that are individually disposed under the alignment electrodes ALE to overlap a portion of each of the alignment electrodes ALE.

The alignment electrode ALE may protrude in an upper direction (e.g., a third direction DR3 crossing a plane formed by the first direction DR1 and the second direction DR2) around the light emitting elements LD. The first insulating layer INS1 and the alignment electrodes ALE thereon may form a reflective protrusion pattern around the light emitting elements LD. Accordingly, light efficiency of the sub-pixels SPX may be improved.

The first insulating layer INS1 may include an inorganic insulating material and/or an organic insulating material, and may be a single layer or multiple layers. The alignment electrodes ALE may be disposed on the first insulating layer INS1.

The alignment electrodes ALE may include a first alignment electrode ALE1 and a second alignment electrode ALE2. The first alignment electrode ALE1 and the second alignment electrode ALE2 may be adjacent to each other and may be separated from each other. The first alignment electrode ALE1 may be disposed around the first end(s) EP1 of the light emitting element(s) LD, and the second alignment electrode ALE2 may be disposed around the second end(s) EP2 of the light emitting element(s) LD.

In one or more embodiments, the first alignment electrode ALE1 may be connected to the pixel circuit PXC of the corresponding sub-pixel SPX. For example, the first alignment electrode ALE1 may be connected (e.g., electrically connected) to the first transistor M1 of the corresponding sub-pixel SPX through the first contact hole CH1.

In one or more embodiments, the second alignment electrode ALE2 may be connected to the second power line PL2. For example, the second alignment electrode ALE2 may be connected (e.g., electrically connected) to the second horizontal power line HPL2 positioned around the corresponding sub-pixel SPX through the second contact hole CH2.

Each alignment electrode ALE may include at least one conductive material among at least one metal among various suitable metal materials including silver (Ag), magnesium (Mg), aluminum (Al), platinum (Pt), palladium (Pd), gold (Au), nickel (Ni), neodymium (Nd), iridium (Ir), chromium (Cr), titanium (Ti), molybdenum (Mo), copper (Cu), or an alloy thereof, a conductive oxide such as indium tin oxide (ITO), indium zinc oxide (IZO), indium tin zinc oxide (ITZO), zinc oxide (ZnO), aluminum doped zinc oxide (AZO), gallium doped zinc oxide (GZO), zinc tin oxide (ZTO), gallium tin oxide (GTO), and fluorine doped tin oxide (FTO), and a conductive polymer such as PEDOT, but embodiments are not limited thereto. For example, the alignment electrodes ALE may include other conductive materials such as a carbon nanotube or graphene. For example, the alignment electrodes ALE may have conductivity (e.g., may be conductive) by including at least one of various suitable conductive materials. In one or more embodiments, the alignment electrodes ALE may include the same or different conductive materials.

Each alignment electrode ALE may be a single layer or multiple layers. For example, each alignment electrode ALE may include a reflective electrode layer including a reflective conductive material (e.g., a metal), and may be configured as an electrode of a single layer or multiple layers.

The second insulating layer INS2 may be disposed on the alignment electrodes ALE. In one or more embodiments, the second insulating layer INS2 may include openings (or contact holes) to connect each of the alignment electrodes ALE to each of the pixel electrodes ELT.

The second insulating layer INS2 may be a single layer or multiple layers, and may include an inorganic insulating material and/or an organic insulating material. In one or more embodiments, the second insulating layer INS2 may include at least one type of inorganic insulating material including silicon nitride (SiNₓ), silicon oxide (SiOₓ), or silicon oxynitride (SiOₓN_{y}).

As the alignment electrodes ALE are covered by the second insulating layer INS2, the alignment electrodes ALE may be prevented or substantially prevented from being damaged in a subsequent process. In one or more embodiments, a short defect may be prevented or substantially prevented from occurring due to improper connection between the alignment electrodes ALE and the light emitting element(s) LD.

The first bank BNK1 may be disposed in the display area DA in which the alignment electrodes ALE and the second insulating layer INS2 are formed. The first bank BNK1 may be formed in the non-emission area NEA to surround the emission area EA of each pixel PXL. The first bank BNK1 may include a light blocking material including a black matrix material, and/or a reflective material.

At least one light emitting element LD may be provided in each emission area EA (e.g., the emission area EA of each sub-pixel SPX) surrounded by the first bank BNK1. For example, a plurality of light emitting elements LD may be provided in each emission area EA. Each of the light emitting elements LD may emit light of a specific color (e.g., a red color, a blue color, or a green color) and/or white light. In one or more embodiments, the light emitting elements LD may be provided in a form of being sprayed into a solution and provided to each pixel PXL (e.g., each sub-pixel SPX). The light emitting elements LD may be between (e.g., aligned between) the alignment electrodes ALE by alignment signals applied to the alignment electrodes ALE (or alignment lines before being separated into the alignment electrodes ALE of each pixel PXL). For example, when each sub-pixel SPX includes the first alignment electrode ALE1 and the second alignment electrode ALE2 adjacent to each other, the light emitting elements LD may be between (e.g., aligned between) the first alignment electrode ALE1 and the second alignment electrode ALE2. In one or more embodiments, the light emitting elements LD may be between adjacent ones of the alignment electrodes ALE (e.g., the first alignment electrode ALE1 and the second alignment electrode ALE2) in the first direction DR1.

In one or more embodiments, each light emitting element LD may be an ultra-small inorganic light emitting diode as small as a micro scale or a nano scale formed in a structure in which a nitride-based or phosphide-based semiconductor is grown. In one or more embodiments, each light emitting element LD may be an ultra-small inorganic light emitting diode having a rod shape and having a size in a range of several nanometers to several hundreds of micrometers, but embodiments of the present disclosure are not limited thereto.

In one or more embodiments, each light emitting element LD may include an emission stack including a first semiconductor layer SCL1 (e.g., a P-type semiconductor layer), an active layer ACT, and a second semiconductor layer SCL2 (e.g., an N-type semiconductor layer) sequentially disposed in one direction (e.g., a direction from the first end EP1 to the second end EP2). In one or more embodiments, each light emitting element LD may further include an insulating film INF around (e.g., surrounding) an outer circumferential surface of the emission stack (e.g., a side surface of a rod having a shape of a cylinder, a polygonal cylinder, and/or the like). The insulating film INF may not be provided on the first and second ends EP1 and EP2 of the light emitting element LD, or may include an opening exposing a portion of the first and second ends EP1 and EP2.

In one or more embodiments, each light emitting element LD may further include at least one electrode layer ETL positioned at the first end EP1 and/or the second end EP2. For example, each light emitting element LD may further include the electrode layer ETL positioned at the first end EP1 and connected (e.g., electrically connected) to the first semiconductor layer SCL1.

The first semiconductor layer SCL1 may include a semiconductor layer of a first conductivity type. For example, the first semiconductor layer SCL1 may include a P-type semiconductor layer. For example, the first semiconductor layer SCL1 may include the P-type semiconductor layer including a nitride-based or phosphide-based semiconductor material and doped with a dopant (e.g., a P-type dopant) of a first conductivity type such as magnesium (Mg).

The active layer ACT may be formed in a single-quantum well or multiquantum well structure. According to one or more embodiments, a nitride-based or phosphide-based semiconductor material may be used to form the active layer ACT, and various suitable other materials may form the active layer ACT. A position of the active layer ACT may be changed according to a type, a shape, and/or the like of the light emitting element LD. In one or more embodiments, the active layer ACT may emit light having a wavelength of 400 nm to 900 nm, and may use a double hetero-structure.

The second semiconductor layer SCL2 may include a semiconductor layer of a type different from that of the first semiconductor layer SCL1. For example, the second semiconductor layer SCL2 may include an N-type semiconductor layer. For example, the second semiconductor layer SCL2 may be an N-type semiconductor layer including a nitride-based or phosphide-based semiconductor material and doped with a dopant (e.g., an N-type dopant) of a second conductivity type such as silicon (Si), germanium (Ge), or tin (Sn).

The electrode layer ETL may include a transparent conductive material and may be substantially transparent. Accordingly, light generated by the light emitting element LD may pass through the electrode layer ETL.

The insulating film INF may include a transparent insulating material, and may be configured of a single layer or multiple layers. Accordingly, light generated in the active layer ACT may pass through the insulating film INF and may be emitted to the outside of the light emitting element LD. For example, the insulating film INF may include at least one insulating material among silicon oxide (SiOₓ) (e.g., SiO₂), silicon nitride (SiNₓ) (e.g., Si₃N₄), aluminum oxide (AlₓO_{y}) (e.g., Al₂O₃), and titanium oxide (TiₓO_{y}) (e.g., TiO₂), or may include another insulating material.

The third insulating layer INS3 may be disposed on a portion of the light emitting elements LD. In one or more embodiments, the third insulating layer INS3 may be locally disposed on a portion including a central portion of the light emitting elements LD to expose the first and second ends EP1 and EP2 of the light emitting elements LD aligned in the emission area EA of the corresponding sub-pixel SPX. In one or more embodiments, the third insulating layer INS3 may be entirely formed in the display area DA, and may include contact holes exposing the first ends EP1 and the second ends EP2 of the light emitting elements LD. When the third insulating layer INS3 is formed on the light emitting elements LD, the light emitting elements LD may be stably fixed. In one or more embodiments, the sub-pixels SPX or the display area DA may not include the third insulating layer INS3.

The third insulating layer INS3 may be a single layer or multiple layers, and may include an inorganic insulating material and/or an organic insulating material. For example, the third insulating layer INS3 may include various suitable types of organic insulating materials and/or inorganic insulating materials including silicon nitride (SiNₓ), silicon oxide (SiOₓ), silicon oxynitride (SiOₓN_{y}), aluminum oxide (AlₓO_{y}), a photoresist material, and/or the like.

On the both ends of the light emitting elements LD, which are not covered by the third insulating layer INS3, for example, on the first and second ends EP1 and EP2, different pixel electrodes ELT may be disposed and/or formed. For example, a portion of the first electrode ELT1 may be disposed on the first ends EP1 of the light emitting elements LD, and a portion of the second electrode ELT2 may be disposed on the second ends EP2 of the light emitting elements LD. The first electrode ELT1 may be connected (e.g., electrically connected) to the first ends EP1 of the light emitting elements LD, and the second electrode ELT2 may be connected (e.g., electrically connected) to the second ends EP2 of the light emitting elements LD.

The first electrode ELT1 may be disposed on the first alignment electrode ALE1 to overlap a portion of the first alignment electrode ALE1. In one or more embodiments, the first electrode ELT1 may be connected (e.g., electrically connected) to the first alignment electrode ALE1 through at least one contact unit (e.g., at least one opening formed in the second insulating layer INS2 on the first alignment electrode ALE1), and may be connected (e.g., electrically connected) to the pixel circuit PXC of the corresponding sub-pixel SPX through the first alignment electrode ALE1. In one or more embodiments, the first electrode ELT1 may be connected (e.g., electrically connected) to the pixel circuit PXC or the first power line PL1 of the corresponding sub-pixel SPX without passing through the first alignment electrode ALE1.

The second electrode ELT2 may be disposed on the second alignment electrode ALE2 to overlap a portion of the second alignment electrode ALE2. In one or more embodiments, the second electrode ELT2 may be connected (e.g., electrically connected) to the second alignment electrode ALE2 through at least one contact unit (e.g., at least one opening formed in the second insulating layer INS2 on the second alignment electrode ALE2), and may be connected (e.g., electrically connected) to the second power line PL2 (e.g., the second horizontal power line HPL2) through the second alignment electrode ALE2. In one or more embodiments, the second electrode ELT2 may be connected (e.g., electrically connected) to the second power line PL2 without passing through the second alignment electrode ALE2.

In one or more embodiments, the first electrode ELT1 and the second electrode ELT2 may be disposed on or at the same layer, and may be formed concurrently (e.g., simultaneously) or sequentially. In one or more embodiments, the first electrode ELT1 and the second electrode ELT2 may be disposed on or at different layers with at least one insulating layer or an insulating pattern interposed therebetween, and may be sequentially formed. A mutual position, a formation order, and/or the like of the pixel electrodes ELT may be changed according to embodiments.

In one or more embodiments, when each sub-pixel SPX includes the light emitting unit EMP of a series structure or a series-parallel structure including at least two series stages, the sub-pixel SPX may further include an additional another alignment electrode ALE and/or pixel electrode ELT.

The pixel electrodes ELT may include a conductive material. In one or more embodiments, the pixel electrodes ELT may include a transparent conductive material and may be substantially transparent. Accordingly, the light generated by the light emitting elements LD may pass through the pixel electrodes ELT.

The fourth insulating layer INS4 may be disposed in the display area DA in which the pixel electrodes ELT are formed. In one or more embodiments, the fourth insulating layer INS4 may be entirely formed in the display area DA. In one or more embodiments, the fourth insulating layer INS4 may be individually formed in each pixel area PXA (e.g., sub-pixel area).

The fourth insulating layer INS4 may be a single layer or multiple layers, and may include an inorganic insulating material and/or an organic insulating material. The fourth insulating layer INS4 may be formed on each light emitting unit EMP and may protect the light emitting unit EMP. In one or more embodiments, the display area DA may not include the fourth insulating layer INS4.

In one or more embodiments, the display panel DPN may include the light conversion layer CCL disposed in the emission area EA of each sub-pixel SPX. For example, in the display panel DPN, the light conversion layer CCL corresponding to each sub-pixel SPX may be provided on the light emitting unit EMP of each sub-pixel SPX.

In one or more embodiments, the display panel DPN may further include the second bank BNK2 disposed in the non-emission area NEA to overlap the first bank BNK1. The second bank BNK2 may define or partition each emission area EA in which the light conversion layer CCL is to be formed. In one or more embodiments, the second bank BNK2 may be integrated with the first bank BNK1.

The second bank BNK2 may include a light blocking material including a black matrix material, and/ or a reflective material. The second bank BNK2 may include a material identical to or different from that of the first bank BNK1.

The light conversion layer CCL may include light conversion particles LCP. The light conversion particles LCP may include at least one of wavelength conversion particles (or color conversion particles) (e.g., a quantum dot converting the light emitted from the light emitting elements LD into light of a color corresponding to the corresponding sub-pixel SPX) for converting a wavelength and/or a color of the light emitted from the light emitting elements LD, and light scattering particles for increasing light output efficiency of the pixel PXL by scattering the light emitted from the light emitting elements LD.

For example, when the sub-pixel SPX is set as a red or green sub-pixel SPX, and blue light emitting elements LD are provided in the light emitting unit EMP of the sub-pixel SPX, the light conversion layer CCL provided in the emission area EA of the sub-pixel SPX may include light conversion particles LCP including a red or green quantum dot for converting blue light into red or green light. In one or more embodiments, the light conversion particles LCP may further include light scattering particles.

When another sub-pixel SPX is set as a blue sub-pixel SPX and blue light emitting elements LD are provided in the light emitting unit EMP of the other sub-pixel SPX, the light conversion layer CCL provided in the emission area EA of the sub-pixel SPX may include the light conversion particles LCP including the light scattering particles.

The fifth insulating layer INS5 may be formed on one surface of the base layer BSL including the light emitting units EMP and/or the light conversion layers CCL of the sub-pixels SPX. The fifth insulating layer INS5 may be a single layer or multiple layers, and may include an organic insulating material and/or an inorganic insulating material.

In one or more embodiments, the fifth insulating layer INS5 may include an organic insulating layer and may be disposed (e.g., entirely disposed) in the display area DA. The fifth insulating layer INS5 may substantially planarize a surface of the display unit DPL and protect the light emitting units EMP and/or the light conversion layers CCL of the sub-pixels SPX.

The color filter unit CFL may be disposed on the fifth insulating layer INS5.

The color filter unit CFL may include color filters CF corresponding to colors of the sub-pixels SPX. For example, the color filter unit CFL may include a first color filter CF1 disposed in the emission area EA of the first sub-pixel SPX1, a second color filter CF2 disposed in the emission area EA of the second sub-pixel SPX2, and a third color filter CF3 disposed in the emission area EA of the third sub-pixel SPX3. Each color filter CF may be provided on the fifth insulating layer INS5 to overlap the light emitting unit EMP of the corresponding sub-pixel SPX.

In one or more embodiments, the first, second, and third color filters CF1, CF2, and CF3 may be disposed to overlap each other in the non-emission area NEA. In one or more embodiments, the first, second, and third color filters CF1, CF2, and CF3 may be formed to be separated from each other in the emission areas EA of the sub-pixels SPX, and a separate light blocking pattern and/or the like may be disposed between the first, second, and third color filters CF1, CF2, and CF3.

The encapsulation unit ENC may be disposed on the color filter unit CFL. The encapsulation unit ENC may include a sixth insulating layer INS6. The sixth insulating layer INS6 may be a single layer or multiple layers, and may include an organic insulating material and/or an inorganic insulating material. In one or more embodiments, the sixth insulating layer INS6 may be entirely formed in at least the display area DA to cover the circuit unit PCL, the display unit DPL, and/or the color filter unit CFL, and may planarize a surface of the display panel DPN. In one or more embodiments, the display panel DPN may be manufactured so as not to include the encapsulation unit ENC, and a separately manufactured protective film and/or the like may be attached to the display panel DPN.

FIG. 5 is a plan view illustrating a circuit unit PCL of a display area DA according to one or more embodiments of the present disclosure. For example, FIG. 5 illustrates a layout embodiment of the circuit unit PCL based on the pixel circuit area PXCA in which the pixel circuits PXC included in the pixel PXL of FIG. 3 are disposed. In describing the embodiments of the present disclosure, the same reference numerals are given to configurations that are similar to or identical to each other, and a repeated description thereof may not be provided.

Referring to FIGS. 1 to 5, the circuit unit PCL may include the pixel circuits PXC disposed in the pixel circuit area PXCA of each pixel PXL. The pixel circuit area PXCA may be defined in the pixel area PXA of the corresponding pixel PXL.

In one or more embodiments, each pixel circuit area PXCA may include the circuit areas SPXA corresponding to each of the pixel circuits PXC. For example, each pixel circuit area PXCA may include a first circuit area SPXA1 including the first pixel circuit PXC1, a second circuit area SPXA2 including the second pixel circuit PXC2, and a third circuit area SPXA3 including the third pixel circuit PXC3.

The circuit unit PCL may further include lines connected to the pixels PXL. For example, the circuit unit PCL may further include the scan lines SL, the data lines DL, the sensing lines SENL, and the first and second power lines PL1 and PL2.

The circuit unit PCL may further include contact holes CH for connecting (e.g., electrically connecting) circuit elements, electrodes, conductive patterns, and/or lines disposed in the circuit unit PCL to each other. In FIG. 5, a symbol is shown to only one contact hole CH that is representative of the contact holes CH for connecting specific elements in the circuit unit PCL.

The circuit unit PCL may further include first contact holes CH1, second contact holes CH2, and third contact holes CH3 formed between the circuit unit PCL and the display unit DPL.

Each of the first contact holes CH1 may connect each pixel circuit PXC and the light emitting unit EMP corresponding thereto. For example, the first contact hole CH1 formed in each first sub-pixel SPX1 may be formed between the first pixel circuit PXC1 and the first alignment electrode ALE1 of the first light emitting unit EMP1. The first contact hole CH1 formed in each second sub-pixel SPX2 may be formed between the second pixel circuit PXC2 and the first alignment electrode ALE1 of the second light emitting unit EMP2. The first contact hole CH1 formed in each third sub-pixel SPX3 may be formed between the third pixel circuit PXC3 and the first alignment electrode ALE1 of the third light emitting unit EMP3.

The second contact holes CH2 may connect the second power line PL2 and the second alignment electrodes ALE2 of the light emitting units EMP. For example, the second contact holes CH2 may be formed between each of the second horizontal power lines HPL2 and the second alignment electrodes ALE2 of the light emitting units EMP positioned around the second horizontal power lines HPL2. Accordingly, in a manufacturing process of the pixels PXL (e.g., an alignment process of the light emitting elements LD), the second alignment signal may be applied to the second alignment electrodes ALE2 through the second power line PL2.

The third contact holes CH3 may connect the first power line PL1 and floating patterns of the display unit DPL. For example, the third contact holes CH3 may be formed between each of the first horizontal power lines HPL1 and the floating patterns overlapping the first horizontal power lines HPL1. The floating patterns may be first formed integrally with the first alignment electrodes ALE1 of the sub-pixels SPX to configure the first alignment line together with the first alignment electrodes ALE1. Accordingly, in the alignment process of the light emitting elements LD, the first alignment signal may be supplied to the first alignment line through the first power line PL1. After the alignment process of the light emitting elements LD is completed, the first alignment line may be disconnected around the third contact holes CH3 to separate the floating patterns from the first alignment electrodes ALE1 of the sub-pixels SPX. Accordingly, the sub-pixels SPX may be individually driven.

Each pixel circuit PXC may include the first transistor M1, the second transistor M2, the third transistor M3, and the capacitor Cst disposed in each circuit area SPXA. For example, the first pixel circuit PXC1 may include the first transistor M1, the second transistor M2, the third transistor M3, and the capacitor Cst disposed in the first circuit area SPXA1 of the corresponding pixel area PXA. The second pixel circuit PXC2 may include the first transistor M1, the second transistor M2, the third transistor M3, and the capacitor Cst disposed in the second circuit area SPXA2 of the corresponding pixel area PXA. The third pixel circuit PXC3 may include the first transistor M1, the second transistor M2, the third transistor M3, and the capacitor Cst disposed in the third circuit area SPXA3 of the corresponding pixel area PXA.

Each of the first transistors M1 may include a first semiconductor pattern SCP1, a first gate electrode GE1, a first source electrode SE1, and a first drain electrode DE1. In one or more embodiments, each first transistor M1 may further include a bottom metal layer BML overlapping the first gate electrode GE1.

The first semiconductor pattern SCP1 may overlap the first gate electrode GE1 and the bottom metal layer BML, and may be connected to the first source electrode SE1 and the first drain electrode DE1. For example, both ends of the first semiconductor pattern SCP1 may be connected to the first source electrode SE1 and the first drain electrode DE1 through respective contact holes CH.

The first gate electrode GE1 may be connected to the lower electrode LE of the capacitor Cst and a second source electrode SE2. For example, the first gate electrode GE1 may be integral with the lower electrode LE of the capacitor Cst, and may be connected to the second source electrode SE2 through at least one contact hole CH.

The first source electrode SE1 may be connected to the upper electrode UE of the capacitor Cst and the third source electrode SE3. For example, the first source electrode SE1 may be integrated with the upper electrode UE of the capacitor Cst and the third source electrode SE3. In one or more embodiments, the first source electrode SE1 may be connected to the first electrode ELT1 formed in the light emitting unit EMP of the corresponding sub-pixel SPX through each first contact hole CH1. For example, the first source electrode SE1 of the first pixel circuit PXC1, the upper electrode UE of the capacitor Cst, and the third source electrode SE3 may be connected to the first alignment electrode ALE1 of the first light emitting unit EMP1 through the first contact hole CH1 connecting the first pixel circuit PXC1 and the first light emitting unit EMP1, and may be connected to the first electrode ELT1 of the first light emitting unit EMP1 through the first alignment electrode ALE1.

The first drain electrode DE1 may be connected to the first power line PL1. For example, the first drain electrode DE1 may be connected to the first vertical power line VPL1 through at least one contact hole CH.

The bottom metal layer BML may overlap the first semiconductor pattern SCP1 and the first gate electrode GE1, and may be connected to the first source electrode SE1. For example, the bottom metal layer BML may be connected to the first source electrode SE1 through at least one contact hole CH.

Each second transistor M2 may include a second semiconductor pattern SCP2, a second gate electrode GE2, the second source electrode SE2, and a second drain electrode DE2.

The second semiconductor pattern SCP2 may overlap the second gate electrode GE2 and may be connected to the second source electrode SE2 and the second drain electrode DE2. For example, both ends of the second semiconductor pattern SCP2 may be connected to the second source electrode SE2 and the second drain electrode DE2 through respective contact holes CH.

The second gate electrode GE2 may be connected to the scan line SL. For example, the second gate electrode GE2 may be connected to each scan line SL (e.g., the i-th scan line SLi) through at least one contact hole CH.

The second source electrode SE2 may be connected to the lower electrode LE of the capacitor Cst and the first gate electrode GE1. For example, the second source electrode SE2 may be connected to the lower electrode LE of the capacitor Cst and the first gate electrode GE1 through at least one contact hole CH.

The second drain electrode DE2 may be connected to the sub-data line of the corresponding sub pixel SPX. For example, the second drain electrode DE2 of the first pixel circuit PXC1 may be connected to the first sub-data line D1 through at least one contact hole CH. The second drain electrode DE2 of the second pixel circuit PXC2 may be connected to the second sub-data line D2 through at least one contact hole CH. The second drain electrode DE2 of the third pixel circuit PXC3 may be connected to the third sub-data line D3 through at least one contact hole CH.

Each third transistor M3 may include a third semiconductor pattern SCP3, a third gate electrode GE3, a third source electrode SE3, and a third drain electrode DE3.

The third semiconductor pattern SCP3 may overlap the third gate electrode GE3 and may be connected to the third source electrode SE3 and the third drain electrode DE3. For example, both ends of the third semiconductor pattern SCP3 may be connected to the third source electrode SE3 and the third drain electrode DE3 through respective contact holes CH.

The third gate electrode GE3 may be connected to each scan line SL or may be connected to the separate control line SSL separated from the scan line SL. In one or more embodiments, the third gate electrode GE3 may be integral with the second gate electrode GE2 and may be connected to each scan line SL through at least one contact hole CH.

The third source electrode SE3 may be connected to the upper electrode UE of the capacitor Cst and the first source electrode SE1. For example, the third source electrode SE3 may be integrated with the upper electrode UE of the capacitor Cst and the first source electrode SE1.

The third drain electrode DE3 may be connected to the sensing line SENL. For example, the third drain electrode DE3 may be connected to the sensing line SENL through at least one contact hole CH.

The capacitor Cst may include the lower electrode LE and the upper electrode UE.

The lower electrode LE of the capacitor Cst may be connected to the first gate electrode GE1 and the second source electrode SE2. For example, the lower electrode LE of the capacitor Cst may be integrated with the first gate electrode GE1 and the second source electrode SE2.

The upper electrode UE of the capacitor Cst may be connected to the first source electrode SE1 and the third source electrode SE3. For example, the upper electrode UE of the capacitor Cst may be integrated with the first source electrode SE1 and the third source electrode SE3.

In one or more embodiments, the bottom metal layers BML provided in the display area DA and at least some lines extending in the second direction DR2 may be disposed on or at the same layer of the circuit unit PCL. For example, the bottom metal layers BML, the second signal lines VSGL (e.g., the sensing lines SENL and the data lines DL), the first vertical power lines VPL1, and the second vertical power lines VPL2 may be disposed on the first conductive layer of the circuit unit PCL, and may be concurrently (e.g., simultaneously) formed.

In one or more embodiments, the semiconductor patterns SCP provided in the display area DA may be disposed on or at the same layer of the circuit unit PCL. For example, the semiconductor patterns SCP may be disposed on the semiconductor layer of the circuit unit PCL, and may be concurrently (e.g., simultaneously) formed.

In one or more embodiments, the gate electrodes GE and the lower electrodes LE of the capacitors Cst provided in the display area DA may be disposed on or at the same layer of the circuit unit PCL. For example, the gate electrodes GE and the lower electrodes LE of the capacitors Cst may be disposed on the second conductive layer (e.g., a gate layer) of the circuit unit PCL, and may be concurrently (e.g., simultaneously) formed. In one or more embodiments, when at least one line extending in the first direction DR1 or the second direction DR2 is formed as multiple layers, the at least one line may selectively include a conductive pattern (e.g., a sub-line) disposed on the second conductive layer of the circuit unit PCL.

In one or more embodiments, the source electrodes SE, the drain electrodes DE, the upper electrodes UE of the capacitors Cst, and/or some lines extending in the first direction DR1, which are provided in the display area DA, may be disposed on or at the same layer of the circuit unit PCL. For example, the source electrodes SE, the drain electrodes DE, the upper electrodes UE of the capacitors Cst, the first horizontal power lines HPL1, and the second horizontal power lines HPL2 may be disposed on the third conductive layer (e.g., a sourcedrain layer) of the circuit unit PCL. In one or more embodiments, when at least one line extending in the second direction DR2 is formed as multiple layers, the at least one line may selectively include a conductive pattern (e.g., a sub-line) disposed on the third conductive layer of the circuit unit PCL.

According to the above-described embodiment, the area occupied by each pixel circuit PXC may be reduced by efficiently disposing circuit elements and lines of the circuit unit PCL. Accordingly, the pixel PXL according to the above-described embodiment may be usefully applied to the high-resolution display device DD in which the area of the individual pixel area PXA is small as in the high-resolution display device DD. In one or more embodiments, according to the above-described embodiment, the line spaces LA for forming additional lines may be appropriately secured.

In one or more embodiments, the line spaces LA may be provided around each pixel circuit area PXCA. For example, first line spaces LA1 may be provided on left and right sides of each pixel circuit area PXCA, and second line spaces LA2 may be provided above and below each pixel circuit area PXCA.

In one or more embodiments, in the line spaces LA, connection lines (e.g., connection lines CLI of FIGS. 6 to 8) and bridges (e.g., bridges BRP of FIGS. 6 to 8) for connecting the first signal lines HSGL of the display area DA and/or the second signal lines VSGL positioned at one portion of the display area DA to the pads (e.g., pads P of FIGS. 6 to 8) may be disposed. In one or more embodiments, dummy lines (e.g., dummy lines DLI of FIGS. 6 to 8) may be selectively disposed in the line spaces LA. In one or more embodiments, each dummy line DLI may be connected to a power line PL (e.g., the first power line PL1 or the second power line PL2), and may configure one portion of the power line PL. Accordingly, voltage drop of a power voltage may be reduced or minimized, and image quality of the display device DD may be improved.

FIGS. 6 to 8 are plan views illustrating a display panel DPN according to embodiments of the present disclosure. For example, FIGS. 6 to 8 illustrate different embodiments of a line structure for one block BLK of the display panel DPN shown in FIG. 1.

In one or more embodiments, the display panel DPN may include blocks BLK having structures that are substantially similar to or identical to each other. For example, in the display panel DPN, the line structure of FIG. 6 may be repeated along the first direction DR1. In one or more embodiments, the display device DD may include a single block BLK and a single pad area PA, and one block BLK of FIG. 6 may correspond to the entire area of the display panel DPN.

First, referring to FIGS. 1 to 6, the display panel DPN or each block BLK of the display panel DPN may include the display area DA and the pad area PA. The pad area PA may be disposed at one edge of each block BLK to be adjacent to one side of the display area DA. For example, the pad area PA may be disposed in the non-display area NA positioned at a lower edge of each block BLK and may be positioned at one side of the display area DA in the second direction DR2.

The display area DA may include a first area A1, a second area A2, and a third area A3. The first area A1, the second area A2, and the third area A3 may be partitioned based on the first direction DR1, and may be areas corresponding to respective sections in the first direction DR1. For example, the display area DA may include the first area A1, the second area A2, and the third area A3 in the first direction DR1. Each of the first area A1, the second area A2, and the third area A3 may include at least two pixel columns and have a predetermined width (e.g., a width corresponding to the number of pixel columns preset for each area) in the first direction DR1.

In one or more embodiments, the display area DA may further include a fourth area A4 positioned around the third area A3. For example, the fourth area A4 may be positioned between the second area A2 and the third area A3. The fourth area A4 may include at least one pixel column and may have a predetermined width (e.g., a width corresponding to the number of preset pixel columns) in the first direction DR1.

In one or more embodiments, each block BLK may include at least two first areas A1, second areas A2, and/or fourth areas A4. For example, the third area A3 may be positioned at a center of the display area DA (e.g., the entire display area DA) of each block BLK based on the first direction DR1. One first area A1, one second area A2, and/or one fourth area A4 may be positioned on both sides of the third area A3. For example, a first area A1, a second area A2, and/or a fourth area A4 may be on or at a first side of the third area A3 and another first area A1, another second area A2, and/or another fourth area A4 may be on or at a second side of the third area A3 opposite to the first side.

The first area A1 may be positioned at both edges (e.g., opposite edges) of the display area DA (e.g., the entire display area DA) of each block BLK in the first direction DR1. The second area A2 may be positioned between the first area A1 and the third area A3. For example, the second area A2 may be an area directly adjacent to the first area A1 in the first direction DR1. The fourth area A4 may be positioned between the first area A1 and the third area A3. For example, the fourth area A4 may be positioned between the second area A2 and the third area A3. However, embodiments of the present disclosure are not limited thereto. For example, a position of the fourth area A4 may be changed in any suitable manner.

In the display area DA, the first signal lines HSGL, the second signal lines VSGL, the connection lines CLI, and the bridges BRP may be disposed. In one or more embodiments, the dummy lines DLI may be further disposed in the display area DA.

The first area A1 may include the dummy lines DLI extending in the second direction DR2 or may not include the dummy lines DLI. For example, the dummy lines DLI may be selectively disposed in the first area A1. The second area A2, the third area A3, and the fourth area A4 may include different connection lines CLI extending in the second direction DR2. For example, the second area A2 may include first connection lines CLI1 (also referred to as "first lines"), and the third area A3 may include second connection lines CLI2 (also referred to as "second lines"). The fourth area A4 may include at least one third connection line CLI3 (also referred to as a "third line").

The first signal lines HSGL may extend in the first direction DR1 and may be arranged along the second direction DR2 crossing the first direction DR1. The first signal lines HSGL may be commonly formed in the first area A1, the second area A2, the third area A3, and the fourth area A4. For example, the first signal lines HSGL may extend in the first direction DR1 in the display area DA and may be commonly formed in the blocks BLK of the display panel DPN.

The first signal lines HSGL may be connected (e.g., electrically connected) to the pixels PXL positioned in respective pixel rows. For example, at least one first signal line HSGL (e.g., the i-th scan line SLi) positioned in the i-th pixel row may be commonly connected to the pixels PXL positioned in the i-th pixel row.

The first signal lines HSGL may be connected (e.g., electrically connected) to respective second connection lines CLI2 in the third area A3 of at least one block BLK, and may be connected (e.g., electrically connected) to respective pads P (e.g., respective third pads P3) through the respective second connection lines CLI2. For example, each first signal line HSGL may be connected (e.g., electrically connected) to at least one third pad P3 through at least one second connection line CLI2 positioned in the third area A3 of at least one block BLK.

In FIG. 6, all of the first signal lines HSGL disposed in the display area DA are connected to the second connection lines CLI2 provided in the third area A3 of one block BLK, but embodiments of the present disclosure are not limited thereto. For example, the first signal lines HSGL may be divided into at least two groups, and the first signal lines HSGL included in different groups may be connected (e.g., electrically connected) to the second connection lines CLI2 and the third pads P3 provided in different blocks BLK. In one or more embodiments, the first signal lines HSGL of each group may be connected (e.g., electrically connected) to the second connection lines CLI2 and the third pads P3 provided in one block BLK, or may be connected (e.g., electrically connected) to two or more blocks (BLK) may be connected (e.g., electrically connected) to the second connection lines CLI2 and the third pads P3 provided in two or more blocks BLK.

The second signal lines VSGL may extend in the second direction DR2 crossing the first direction DR1. The second signal lines VSGL may include second signal lines VSGL1 of a first group positioned in the first area A1, second signal lines VSGL2 of a second group positioned in the second area A2, second signal lines VSGL3 of a third group positioned in the third area A3, and second signal lines VSGL4 of a fourth group positioned in the fourth area A4.

The second signal lines VSGL1 of the first group may extend in the second direction DR2 in the first area A1 and may be disposed in respective pixel columns positioned in the first area A1. The respective second signal lines VSGL1 of the first group may be connected (e.g., electrically connected) to the pixels PXL disposed in the corresponding pixel columns of the first area A1.

The second signal lines VSGL1 of the first group may be connected (e.g., electrically connected) to the respective first connection lines CLI1 positioned in the second area A2 through the respective bridges BRP. The second signal lines VSGL1 of the first group may be connected (e.g., electrically connected) to the respective pads P (e.g., respective first pads P1) through the respective first connection lines CLI1. For example, each of the second signal lines VSGL1 of the first group may be connected (e.g., electrically connected) to the corresponding first pad P1 through the corresponding first connection line CLI1 positioned in the second area A2 of the corresponding block BLK.

The second signal lines VSGL2 of the second group, the second signal lines VSGL3 of the third group, and the second signal lines VSGL4 of the fourth group may extend in the second direction DR2 in the second area A2, the third area A3, and the fourth area A4, respectively, and may be disposed in the respective pixel columns positioned in the second area A2, the third area A3, and the fourth area A4. The second signal lines VSGL2 of the second group, the second signal lines VSGL3 of the third group, and the second signal lines VSGL4 of the fourth group may be connected to the pad area PA from the second area A2, the third area A3, and the fourth area A4, respectively, and may be connected (e.g., electrically connected) to the respective pads P disposed in the pad area PA. For example, the second signal lines VSGL2 of the second group may extend in the second direction DR2 from the second area A2 to be connected to a first pad area PA1, and may be connected (e.g., electrically connected) to respective second pads P2 disposed in the first pad area PA1. The second signal lines VSGL3 of the third group may extend in the second direction DR2 from the third area A3 to be connected to a second pad area PA2, and may be connected (e.g., electrically connected) to respective fourth pads P4 disposed in the second pad area PA2. The second signal lines VSGL4 of the fourth group may extend in the second direction DR2 from the fourth area A4 to be connected to a third pad area PA3, and may be connected (e.g., electrically connected) to respective sixth pads P6 disposed in the third pad area PA3.

The connection lines CLI may include the first connection lines CLI1 and the second connection lines CLI2. In one or more embodiments, the connection lines CLI may further include at least one third connection line CLI3. For example, the connection lines CLI may include one or more third connection lines CLI3 disposed in each of two fourth areas A4 positioned on or at opposite sides of the third area A3.

The first connection lines CLI1, the second connection lines CLI2, and the third connection lines CLI3 may extend in the second direction DR2 in the second area A2, the third area A3, and the fourth area A4, respectively, and may be disposed in the respective pixel columns positioned in the second area A2, the third area A3, and the fourth area A4. The first connection lines CLI1, the second connection lines CLI2, and the third connection lines CLI3 may be connected from the display area DA to the pad area PA, and may be connected (e.g., electrically connected) to the respective pads P disposed in the pad area PA. For example, the first connection lines CLI1 may extend in the second direction DR2 from the second area A2 to be connected to the first pad area PA1, and may be connected (e.g., electrically connected) to the respective first pads P1 disposed in the first pad area PA1. The second connection lines CLI2 may extend in the second direction DR2 from the third area A3 to be connected to the second pad area PA2, and may be connected (e.g., electrically connected) to the respective third pads P3 disposed in the second pad area PA2. The third connection lines CLI3 may extend in the second direction DR2 from the fourth area A4 to be connected to the third pad area PA3, and may be connected (e.g., electrically connected) to respective fifth pads P5 disposed in the third pad area PA3. Each third connection line CLI3 may be connected (e.g., electrically connected) to any one power line PL (e.g., the first power line PL1, the second power line PL2, or another power line (e.g., the initialization power line, a ground power line, or a reference power line)) in the fourth area A4.

The dummy lines DLI may extend in the second direction DR2 in the first area A1 and may not extend to the pad area PA. For example, the dummy lines DLI may be disposed in the respective pixel columns positioned in the first area A1, and may be disconnected at or around a boundary between the display area DA and the non-display area NA.

In one or more embodiments, at least some of the dummy lines DLI may be connected (e.g., electrically connected) to at least one line among the signal lines (e.g., the first signal lines HSGL and the second signal lines VSGL) and the power lines PL (e.g., the first power line PL1 and the second power line PL2) positioned inside the display area DA, and may configure a sub-line of the at least one line. For example, at least a portion of the dummy lines DLI may be connected to the second power line PL2, and may configure a sub-line of the second power line PL2. In one or more embodiments, another portion of the dummy lines DLI may be connected to the first power line PL1, and may configure a sub-line of the first power line PL1. Accordingly, voltage drop of the second power voltage VSS and/or the first power voltage VDD may be reduced or minimized, and the image quality of the display device DD may be improved.

The bridges BRP may be disposed in the display area DA and may extend in the first direction DR1 in the display area DA. For example, the bridges BRP may be disposed in the first area A1 and the second area A2, and may pass through a boundary between the first area A1 and the second area A2. The bridges BRP may electrically connect the second signal lines VSGL1 of the first group to the respective first connection lines CLI1.

The pad area PA may be positioned at one side of the display area DA in the second direction DR2. For example, the pad area PA may be positioned around the display area DA to be adjacent to the second area A2, the third area A3, and the fourth area A4 in the second direction DR2. The pad area PA may include the first pad area PA1, the second pad area PA2, and the third pad area PA3 corresponding to the second area A2, the third area A3, and the fourth area A4, respectively.

The first pad area PA1 may be positioned at one side of the second area A2 in the second direction DR2. The first pad area PA1 may include the first pads P1 connected (e.g., electrically connected) to the second signal lines VSGL1 of the first group and the second pads P2 connected (e.g., electrically connected) to the second signal lines VSGL2 of the second group through the first connection lines CLI1 and the bridges BRP.

The driving circuit DIC and the second signal lines VSGL1 of the first group may be connected (e.g., electrically connected) to each other through the first pads P1. Accordingly, second driving signals (e.g., the data signals corresponding to the pixels PXL of the first area A1) and/or an initialization power voltage of the first area A1 supplied from the driving circuit DIC may be transmitted to the pixels PXL of the first area A1. In one or more embodiments, the sensing signals corresponding to the characteristic of the pixels PXL of the first area A1 may be transmitted from the pixels PXL of the first area A1 to the driving circuit DIC.

The driving circuit DIC and the second signal lines VSGL2 of the second group may be connected (e.g., electrically connected) to each other through the second pads P2. Accordingly, the second driving signals (e.g., the data signals corresponding to the pixels PXL of the second area A2) and/or the initialization power voltage of the second area A2 supplied from the driving circuit DIC may be transmitted to the pixels PXL of the second area A2. In one or more embodiments, the sensing signals corresponding to the characteristic of the pixels PXL of the second area A2 may be transmitted from the pixels PXL of the second area A2 to the driving circuit DIC.

The second pad area PA2 may be adjacent to the first pad area PA1 and may be positioned at one side of the third area A3 in the second direction DR2. The second pad area PA2 may include the third pads P3 connected (e.g., electrically connected) to the first signal lines HSGL and the fourth pads P4 connected (e.g., electrically connected) to the second signal lines VSGL3 of the third group through the second connection lines CLI2.

The driving circuit DIC and the first signal lines HSGL may be connected (e.g., electrically connected) to each other through the third pads P3. Accordingly, first driving signals (e.g., the scan signals) supplied from the driving circuit DIC may be transmitted to the pixels PXL positioned in the respective pixel rows.

The driving circuit DIC and the second signal lines VSGL3 of the third group may be connected (e.g., electrically connected) to each other through the fourth pads P4. Accordingly, the second driving signals (e.g., the data signals corresponding to the pixels PXL of the third area A3) and/or the initialization power voltage of the third area A3 supplied from the driving circuit DIC may be transmitted to the pixels PXL of the third area A3. In one or more embodiments, the sensing signals corresponding to the characteristic of the pixels PXL of the third area A3 may be transmitted from the pixels PXL of the third area A3 to the driving circuit DIC.

The third pad area PA3 may be positioned at one side of the fourth area A4 in the second direction DR2. The third pad area PA3 may include the fifth pads P5 connected (e.g., electrically connected) to the power lines PL and the sixth pads P6 connected (e.g., electrically connected) to the second signal lines VSGL4 of the fourth group through the third connection lines CLI3.

The driving circuit DIC and/or the power generator and the power lines PL (e.g., the first power line PL1 and the second power line PL2) may be connected (e.g., electrically connected) through the fifth pads P5. Accordingly, the power voltages (e.g., the first power voltage VDD and the second power voltage VSS) supplied from the driving circuit DIC and/or the power generator may be transmitted to the pixels PXL through the respective power lines PL.

The driving circuit DIC and the second signal lines VSGL4 of the fourth group may be connected (e.g., electrically connected) to each other through the sixth pads P6. Accordingly, the second driving signals (e.g., the data signals corresponding to the pixels PXL of the fourth area A4) and/or the initialization power voltage of the fourth area A4 supplied from the driving circuit DIC may be transmitted to the pixels PXL of the fourth area A4. In one or more embodiments, the sensing signals corresponding to the characteristic of the pixels PXL of the fourth area A4 may be transmitted from the pixels PXL of the fourth area A4 to the driving circuit DIC.

A pad-free area PFA corresponding to the first area A1 may be positioned around the pad area PA. For example, the pad-free area PFA may be positioned on or at both sides (e.g., opposite sides) of the pad area PA in the first direction DR1, and may be positioned at one side of the first area A1 in the second direction DR2. The pads P may not be provided in the pad-free area PFA. In one or more embodiments, a distance and/or an interval between the driving circuits DIC may be adjusted by adjusting a width (e.g., a width in the first direction DR1) of the first area A1 and/or the pad-free area PFA.

In one or more embodiments, an antistatic circuit may be provided around the pad area PA. For example, circuit elements (e.g., diodes) of the antistatic circuit may be disposed between the pad area PA and the display area DA.

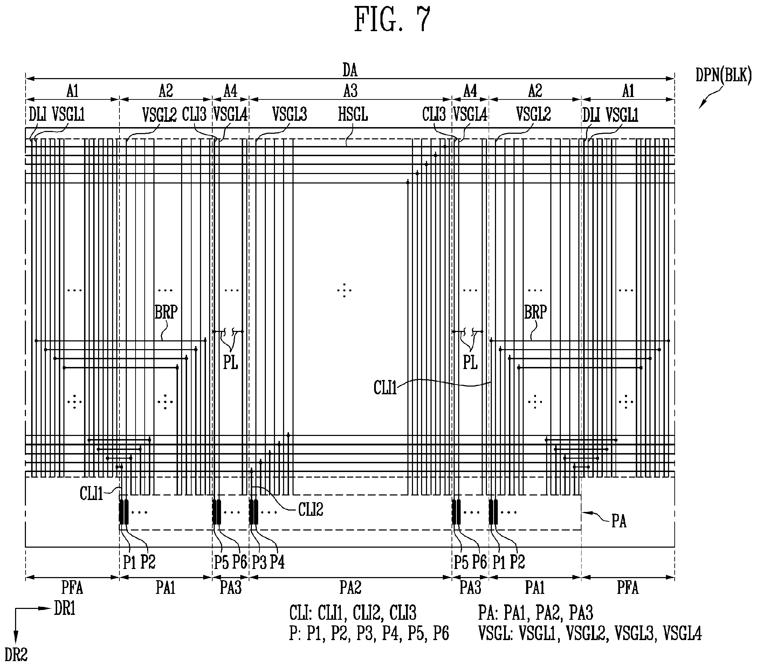

Referring to FIG. 7, at least some of the connection lines CLI may be disposed and/or formed in the display area DA , and a remaining portion of the connection lines CLI may be removed. For example, only a portion of each first connection line CLI1 suitable for connection with the bridge BRP corresponding thereto may be formed, and a remaining portion of each first connection line CLI1 may be removed. Only a portion of each second connection line CLI2 suitable for connection with the first signal line HSGL corresponding thereto may be formed, and a remaining portion of each second connection line CLI2 may be removed. In one or more embodiments, each third connection line CLI3 may extend in the second direction DR2 also after passing a portion suitable for connection with the power line PL. In one or more embodiments, only a portion of each third connection line CLI3 suitable for connection with the power line PL corresponding thereto may be formed, and a remaining portion of each third connection line CLI3 may be removed.

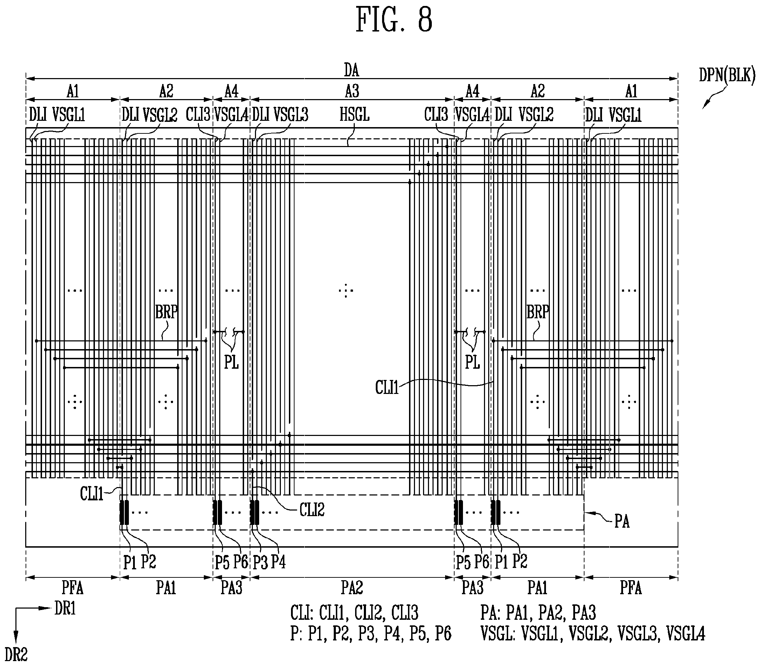

Referring to FIG. 8, at least some of the connection lines CLI may be disposed and/or formed in the display area DA, and may be disconnected after passing through a portion suitable for connection with the respective signal lines and/or power lines PL. Accordingly, the remaining portions separated from the connection lines CLI may remain in the display area DA (e.g., the second area A2 and the third area A3 in a form of respective dummy lines DLI (e.g., dummy patterns). At least some of the dummy lines DLI may be connected (e.g., electrically connected) to at least one line among the signal lines (e.g., the first signal lines HSGL and the second signal lines VSGL) and the power lines PL (e.g., the first power line PL1 and the second power line PL2) positioned inside the display area DA, and may configure a sub-line of the at least one line. For example, at least a portion of the dummy lines DLI of the second area A2, the third area A3, and/or the fourth area A4 may be connected to the second power line PL2 to configure a sub-line of the second power line PL2. In one or more embodiments, another portion of the dummy lines DLI of the second area A2, the third area A3, and/or the fourth area A4 may be connected to the first power line PL1 to configure a sub-line of the first power line PL1. Accordingly, the voltage drop of the second power voltage VSS and/or the first power voltage VDD may be reduced or minimized, and the image quality of the display device DD may be improved.

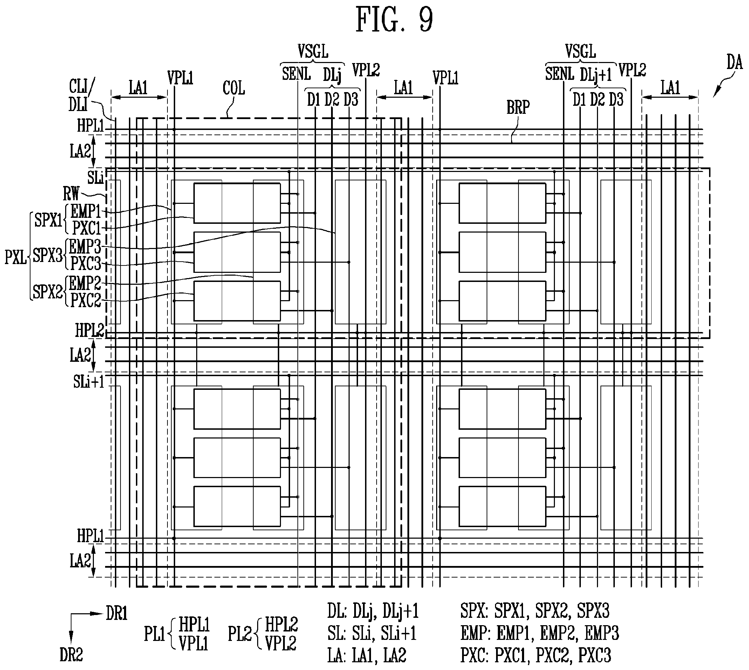

FIGS. 9 to 11 are plan views illustrating a display area DA according to embodiments of the present disclosure. For example, FIGS. 9 to 11 illustrate different embodiments for a line structure of the display area DA based on four pixels PXL (e.g., pixels PXL connected to the i-th scan line SLi and the j-th data line DLj, the i-th scan line SLi and a (j+1)-th data line DLj+1, the (i+1)-th scan line SLi+1 and the j-th data line DLj, and the (i+1)-th scan line SLi+1 and the (j+1)-th data line DLj+1) adjacent to each other along the first direction DR1 and the second direction DR2.

Referring to FIGS. 1 to 11, in the first direction DR1, the first line space LA1 may be provided at both sides (e.g., opposite sides) of each pixel column COL. For example, in the first direction DR1, the first line spaces LA1 may be disposed in first and last pixel columns positioned in or at both edge areas (e.g., opposite edge areas) of the display area DA and/or around the first and last pixel columns, and between and/or around the pixels PXL disposed in two pixels columns COL adjacent in the first direction DR1. Each first line space LA1 may extend in the second direction DR2 in the display area DA.

At least some of the first line spaces LA1 may include at least one connection line CLI and/or dummy line DLI. For example, the first line space LA1 of each pixel column COL positioned in the first area A1 may include at least one dummy line DLI or may not include the dummy line DLI. The first line space LA1 of each pixel column COL positioned in the second area A2 may include at least one first connection line CLI1. The first line space LA1 of each pixel column COL positioned in the third area A3 may include at least one second connection line CLI2. The first line space LA1 of each pixel column COL positioned in the fourth area A4 may include at least one third connection line CLI3.

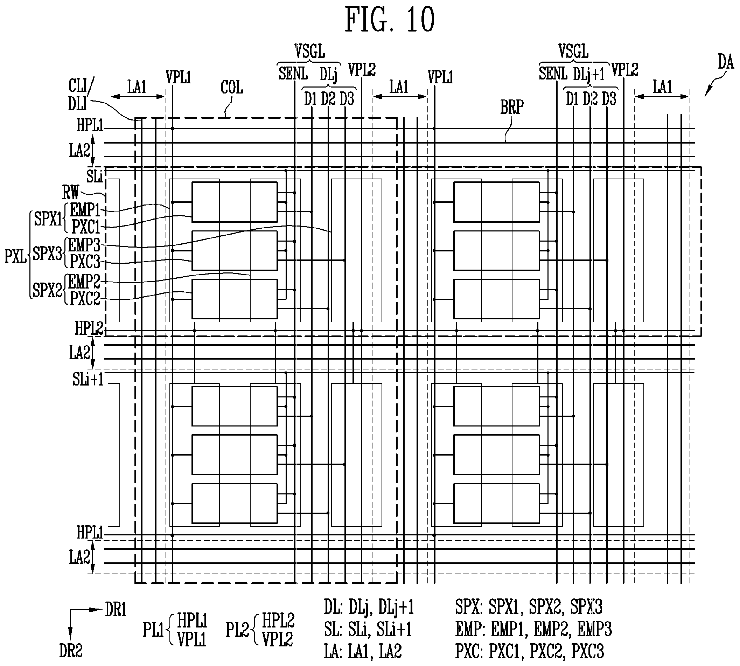

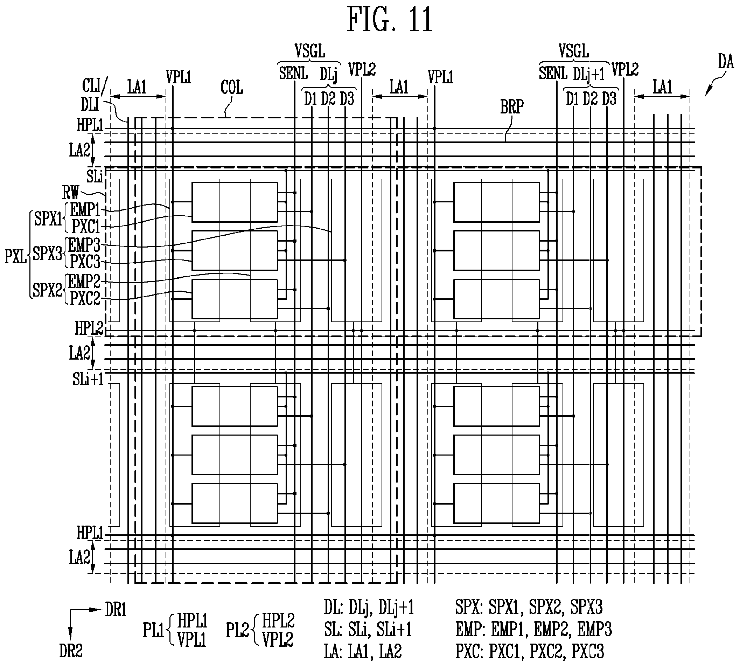

The number, size (e.g., width of each line), and/or position of the connection line(s) CLI and/or the dummy line(s) DLI disposed in the first line space LA1 of each pixel column COL may be variously changed in any suitable manner according to embodiments. For example, in the first line space LA1 of each pixel column COL, four connection lines CLI (e.g., dummy lines DLI) may be disposed as shown in FIG. 9, two connection lines CLI (e.g., dummy lines DLI) may be disposed as shown in FIG. 10, or three connection lines CLI (e.g., dummy lines DLI) may be disposed as shown in FIG. 11. The number of connection line(s) CLI and/or dummy line(s) DLI disposed in each pixel column COL of the first area A1, the second area A2, the third area A3, and/or the fourth area A4 may be identical to each other or different from each other. In one or more embodiments, the connection lines CLI and the dummy lines DLI may be disposed together in at least some of the first line spaces LA1. For example, when four lines are formed in each first line space LA1, at least one of the four lines may be the connection line(s) CLI, and a remaining line may be the dummy line(s) DLI.

In the second direction DR2, the second line spaces LA2 may be provided on both sides (e.g., opposite sides) of each pixel row RW. For example, in the second direction DR2, the second line spaces LA2 may be disposed in first and last pixel rows positioned in or at both edge areas (e.g., opposite edge areas) of the display area DA and/or around the first and last pixel rows, and between two pixel rows RW adjacent in the second direction DR2. Each second line space LA2 may extend in the first direction DR1 in the display area DA.

At least some of the second line spaces LA2 may include at least one bridge (e.g., conductive pattern) BRP. For example, the bridges BRP for connecting the second signal lines VSGL1 of the first group to the respective first connection lines CLI1 may be disposed in at least some of the second line spaces LA2. In one or more embodiments, the bridges BRP may be provided by the number and/or length suitable to connect (e.g., appropriately connect) the second signal lines VSGL1 of the first group to the first connection lines CLI1, and may be disposed only around some of the pixel rows RW.

The number, size (e.g., width and/or length of each bridge BRP), and/or position of the bridge(s) BRP disposed in each pixel row RW may be variously changed in any suitable manner according to embodiments. For example, as shown in FIGS. 9 to 11, two bridges BRP may be respectively disposed between at least some of the pixel rows RW disposed in the display area DA, but embodiments of the present disclosure are not limited thereto. The number, size, and/or position of the bridges BRP may be variously changed in any suitable manner according to a design condition of the display panel DPN including a size (e.g., a width in the second direction DR2) and/or the like of the second line spaces LA2 that may be secured between the pixel rows RW.

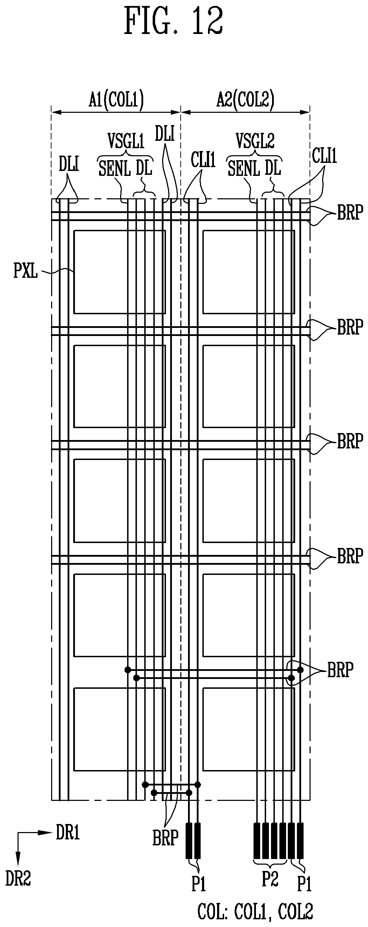

FIGS. 12 to 14 are plan views illustrating a connection structure between second signal lines VSGL1 of a first group, first connection lines CLI1, and first pads P1 according to embodiments of the present disclosure. For example, FIGS. 12 to 14 illustrate each pixel column(s) of the first area A1 (hereinafter, referred to as "first pixel column(s) COL1 ") and pixel column(s) of the second area A2 (hereinafter, referred to as "second pixel column(s) COL2") corresponding to the first pixel column(s) COL1. FIGS. 12 to 14 illustrate different embodiments in relation to the number of first connection lines CLl1 disposed in each second pixel column COL2 and the number or a ratio of second pixel columns COL2 allocated to each first pixel column COL1 according thereto.

Referring to FIGS. 1 to 14, the first area A1 may include the first pixel columns COL1 including different second signal lines VSGL1 among the second signal lines (e.g., the second signal lines VSGL1 of the first group) positioned in the first area A1. For example, each first pixel column COL1 may include four second signal lines VSGL1 including the sensing line SENL, the first sub-data line D1, the second sub-data line D2, and the third sub-data line D3 connected to the pixels PXL of the corresponding first pixel column COL1. In one or more embodiments, each first pixel column COL1 may further include at least one dummy line DLI.

The second area A2 may include the second pixel columns COL2 including different second signal lines VSGL2 among the second signal lines (e.g., the second signal lines VSGL2 of the second group) positioned in the second area A2, and different first connection lines CLI1. For example, each second pixel column COL2 may include four second signal lines VSGL2 including the sensing line SENL, the first sub-data line D1, the second sub-data line D2, and the third sub-data line D3 connected to the pixels PXL of the corresponding second pixel column COL2, and may further include at least one first connection line CLI1 in addition to the second signal lines VSGL2.

Each of the second pixel columns COL2 may include a number of first connection line(s) CLI1 corresponding to a ratio of the number of first pixel columns COL1 disposed in the first area A1 and the number of second pixel columns COL2 disposed in the second area A2. For example, in the second area A2, the number of the first connection lines CLI1 (e.g., the same number as or a multiple of the number of second signal lines VSGL1 of the first area A1) corresponding to the number of the first connection lines CLI1 suitable to connect the second signal lines VSGL1 of the first area A1 to the respective first pads P1 may be disposed, and the first connection lines CLI1 may be divided and disposed in the second pixel columns COL2. Accordingly, each of the second pixel columns COL2 may include the number of the first connection line(s) CLI1 allocated according to the ratio of the number of the first pixel columns COL1 and the number of the second pixel columns COL2.

For example, each of the second pixel columns COL2 may include a number of first connection line(s) CLI1 proportional to a number of first pixel columns COL1 and a number of second signal lines VSGL1 disposed in respective first pixel columns COL1. In one or more embodiments, each of the second pixel columns COL2 may include a number of first connection line(s) CLI1 inversely proportion to a number of second pixel columns COL2 disposed in the second area A2. The number of first connection line(s) CLI1 disposed in each second pixel column COL2 and the number of second pixel columns COL2 allocated to each first pixel column COL1 and/or a ratio thereof may be variously changed in any suitable manner according to embodiments.

Referring to FIG. 12, each second pixel column COL2 may include a number of first connection lines CLI1 that is the same as a number of second signal lines VSGL1 disposed in each first pixel column COL1, and the second area A2 may include a number of second pixel columns COL2 that is the same as a number of first pixel columns COL1 disposed in the first area A1. The first connection lines CLI1 disposed in each second pixel column COL2 may be allocated to any one first pixel column COL1. For example, the first pixel columns COL1 and the second pixel columns COL2 may match in a ratio of 1:1, and the second signal lines VSGL1 disposed in each first pixel column COL1 may be 1:1 connected to the first connection lines CLI1 disposed in each second pixel column COL2. For example, each first pixel column COL1 may include four second signal lines VSGL1, and each second pixel column COL2 may include four first connection lines CLI1 connected to the second signal lines VSGL1 of the first pixel column COL1 corresponding thereto through respective bridges BRP.

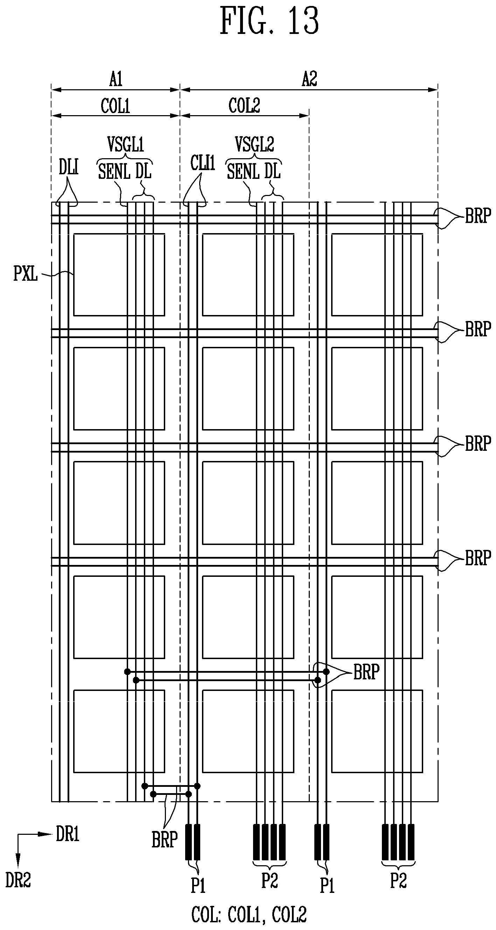

Referring to FIG. 13, each second pixel column COL2 may include a number of first connection lines CLI1 corresponding to 1/K (K is a positive integer equal to or greater than 2) of the number of second signal lines VSGL1 disposed in each first pixel column COL1, and the second area A2 may include a number of second pixel columns COL2 corresponding to K times the number of first pixel columns COL1 disposed in the first area A1. The first connection lines CLI1 disposed in the K second pixel columns COL2 may be allocated to any one first pixel column COL1. For example, the first pixel columns COL1 and the second pixel columns COL2 may match in a ratio of 1:2, and the second signal lines VSGL1 disposed in each of the first pixel columns COL1 may be 1:1 connected to the first connection lines CLl1 disposed in two second pixel columns COL2. For example, each first pixel column COL1 may include four second signal lines VSGL1, and each second pixel column COL2 may include two first connection lines CLI1. The four first connection lines CLI1 provided to the two second pixel columns COL2 corresponding to one first pixel column COL1 may be connected to the second signal lines VSGL1 of the first pixel column COL1 corresponding thereto through respective bridges BRP.

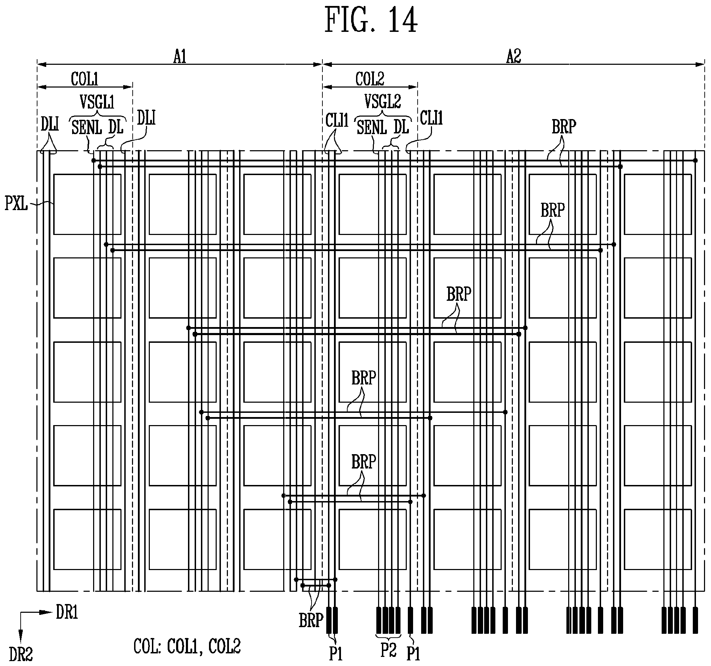

Referring to FIG. 14, a ratio of the number of second signal lines VSGL1 disposed in each first pixel column COL1 and the number of first connection lines CLl1 disposed in each second pixel column COL2 may be N:M (each of N and M is a positive integer equal to or greater than 2), and a ratio of the number of first pixel columns COL1 disposed in the first area A1 and the number of second pixel columns COL2 disposed in the second area A2 may be M:N. For example, each first pixel column COL1 may include four second signal lines VSGL1, and each second pixel column COL2 may include three first connection lines CLI1. In this case, the second area A2 may include a number of second pixel columns COL2 corresponding to 4/3 times (or a multiple thereof) a number of first pixel columns COL1 disposed in the first area A1.

The first connection lines CLl1 disposed in N second pixel columns COL2 may be allocated to M first pixel columns COL1. For example, the first pixel columns COL1 and the second pixel columns COL2 may match in a ratio of 3:4, and twelve second signal lines VSGL1 disposed in three first pixel columns COL1 may be 1:1 connected to twelve first connection lines CLl1 disposed in four second pixel columns COL2.

In one or more embodiments, the display device DD may include a plurality of blocks BLK and twenty-four (24) driving circuits DIC corresponding thereto, as shown in FIG. 1. For example, the display device DD may be a high-resolution display device DD including 7680 pixel columns COL and 4320 pixel rows RW, and may include 24 blocks BLK and 24 driving circuits DIC corresponding thereto.

In one or more embodiments, two second connection lines CLI2 may be disposed for each pixel column COL of the third area A3 provided in each block BLK, and each first signal line HSGL may be connected to three second connection lines CLI2 that are divided and disposed in three blocks BLK. In this case, 270 pixel columns COL corresponding to 4320/24/2*3 may be disposed in the third area A3 of each block BLK.

When 320 pixel columns COL corresponding to 7680/24 are disposed in each of the 24 blocks BLK and 270 pixel columns COL are disposed in the third area A3 of each block BLK, 25 pixel columns COL corresponding to (320-270)/2 may be disposed in each of the first area A1, the second area A2, and the fourth area A4 positioned on a left side of the third area A3, and the first area A1, the second area A2, and the fourth area A4 positioned on a right side of the third area A3.

Among the above embodiments, with respect to an embodiment 1 corresponding to FIG. 12, an embodiment 2 corresponding to FIG. 13, and an embodiment 3 corresponding to FIG. 14, the number of pixel columns COL allocated to each of the first area A1, the second area A2, the third area A3, and the fourth area A4 may be as shown in Table 1 below.

**Table 1**

| | First area (A1) | Second area (A2) | Fourth area (A4) | Third area (A3) | Fourth area (A4) | Second area (A2) | First area (A1) |
|---|---|---|---|---|---|---|---|
| Embodiment 1 | 12 | 12 | 1 | 270 | 1 | 12 | 12 |
| Embodiment 2 | 8 | 16 | 1 | 270 | 1 | 16 | 8 |
| Embodiment 3 | 9 | 12 | 4 | 270 | 4 | 12 | 9 |

For example, when the first pixel columns COL1 and the second pixel columns COL2 are disposed in the first area A1 and the second area A2 in a ratio of 1:1 as in FIG. 12, twelve first pixel columns COL1 and twelve second pixel columns COL2 may be disposed in each of the first area A1 and the second area A2 positioned on the left side of the third area A3, and one pixel column COL may be disposed in the fourth area A4 positioned on the left side of the third area A3. Twelve first pixel columns COL1 and twelve second pixel columns COL2 may be disposed in each of the first area A1 and the second area A2 positioned on the right side of the third area A3, and one pixel column COL may be disposed in the fourth area A4 positioned on the right side of the third area A3. Accordingly, 25 pixel columns COL may be disposed on each of the left side and the right side of the third area A3.

As shown in FIG. 13, when the first pixel columns COL1 and the second pixel columns COL2 are disposed in the first area A1 and the second area A2 in a ratio of 1:2, 8 first pixel columns COL1 and 16 second pixel columns COL2 may be disposed in each of the first area A1 and the second area A2 positioned on the left side of the third area A3, and one pixel column COL may be disposed in the fourth area A4 positioned on the left side of the third area A3. 8 first pixel columns COL1 and 16 second pixel columns COL2 may be disposed in each of the first area A1 and the second area A2 positioned on the right side of the third area A3, and one pixel column COL may be disposed in the fourth area A4 positioned on the right side of the third area A3. Accordingly, 25 pixel columns COL may be disposed on each of the left side and the right side of the third area A3.

As shown in FIG. 14, when the first pixel columns COL1 and the second pixel columns COL2 are disposed in the first area A1 and the second area A2 in a ratio of 3:4, 9 first pixel columns COL1 and 12 second pixel columns COL2 may be disposed in each of the first area A1 and the second area A2 positioned on the left side of the third area A3, and 4 pixel columns COL may be disposed in the fourth area A4 positioned on the left side of the third area A3. 9 first pixel columns COL1 and 12 second pixel columns COL2 may be disposed in each of the first area A1 and the second area A2 positioned on the right side of the third area A3, and 4 pixel columns COL may be disposed in the fourth area A4 positioned on the right side of the third area A3. Accordingly, 25 pixel columns COL may be disposed on each of the left side and the right side of the third area A3.

In addition to the above-described embodiments, the number and/or a ratio thereof of the pixel columns COL disposed in the first area A1, the second area A2, the third area A3, and/or the fourth area A4 may be appropriately adjusted according to a structure, a design condition corresponding thereto, and/or the like of the pixels PXL and the display device DD.

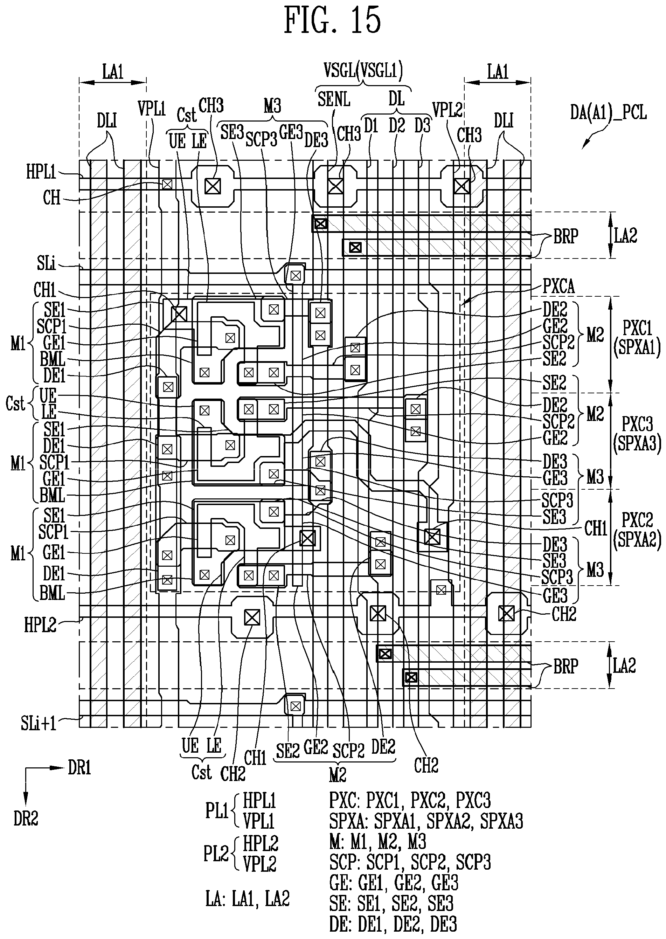

FIG. 15 is a plan view illustrating a circuit unit PCL of a first area A1 according to one or more embodiments of the present disclosure. For example, as in FIG. 5, FIG. 15 illustrates a layout embodiment of the circuit unit PCL of the first area A1 based on one pixel circuit area PXCA and the line areas LA around the pixel circuit area PXCA.

Referring to FIGS. 1 to 15, the dummy lines DLI may be disposed in the first line spaces LA1 of the first area A1. The dummy lines DLI may extend in the second direction DR2 and may be disposed on or at the same layer as the signal lines and/or the power lines PL extending in the second direction DR2. For example, the dummy lines DLI may be disposed on the first conductive layer of the circuit unit PCL together with the second signal lines VSGL, the first vertical power line VPL1, and the second vertical power line VPL2. In one or more embodiments, the dummy lines DLI may be lines of multiple layers, and may further include at least one conductive layer disposed on another layer (e.g., the second conductive layer and/or the third conductive layer of the circuit unit PCL).

The bridges BRP may be disposed in at least some of the second line spaces LA2 of the first area A1. For example, the bridges BRP may be disposed between two pixel rows RW adjacent to each other in the second direction DR2. The bridges BRP may be connected (e.g., electrically connected) to the respective second signal lines VSGL through respective contact holes CH in the first area A1. The bridges BRP may extend in the first direction DR1, and may be disposed on or at the same layer as the signal lines and/or the power lines PL extending in the first direction DR1. For example, the bridges BRP may be disposed on the third conductive layer of the circuit unit PCL together with the first signal lines HSGL, the first horizontal power line HPL1, and the second horizontal power line HPL2.

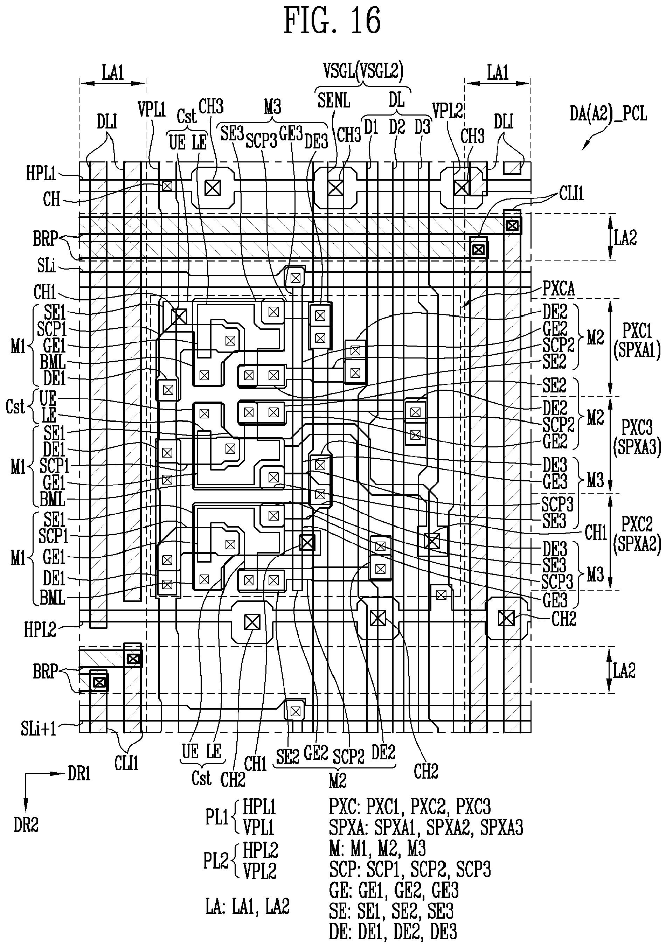

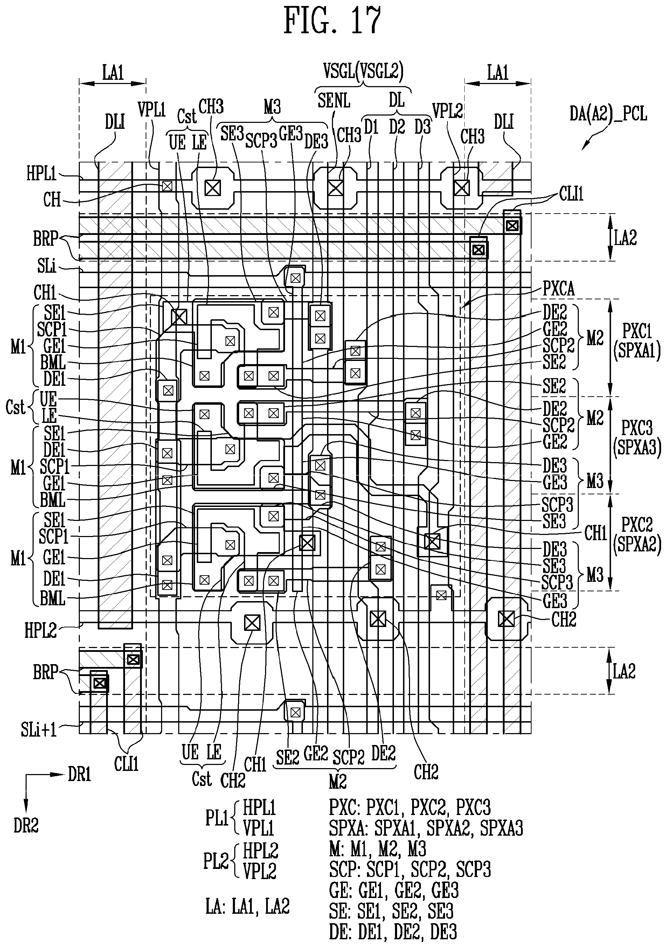

FIGS. 16 and 17 are plan views illustrating a circuit unit PCL of a second area A2 according to embodiments of the present disclosure.

Referring to FIGS. 1 to 17, the first connection lines CLI1 may be disposed in the first line spaces LA1 of the second area A2. For example, each of the first connection lines CLI1 may be disposed in the first line space LA1 positioned between the pixel circuits PXC of the pixels PXL disposed in the second pixel columns COL2 adjacent to each other in the first direction DR1 among the second pixel columns COL2 of the second area A2, or the first line space LA1 positioned around the pixel circuits PXC (e.g., a left side or a right side of the pixel circuits PXC) of the pixels PXL disposed in a first or last second pixel column COL2 of the second area A2.

The first connection lines CLI1 may extend in the second direction DR2, and may be disposed on or at the same layer as the signal lines and/or the power lines PL extending in the second direction DR2. For example, the first connection lines CLI1 may be disposed on the first conductive layer of the circuit unit PCL together with the second signal lines VSGL, the first vertical power line VPL1, and the second vertical power line VPL2. In one or more embodiments, the first connection lines CLI1 may be lines of multiple layers, and may further include at least one conductive pattern disposed on another layer (e.g., the second conductive layer and/or the third conductive layer of the circuit unit PCL). The first connection lines CLI1 may be connected (e.g., electrically connected) to the respective bridges BRP through respective contact holes CH in the second area A2.

In one or more embodiments, in the first line spaces LA1 of the second area A2, the dummy lines DLI may be further disposed. For example, the respective first connection lines CLI1 may be disconnected after passing through respective contact holes CH, and the dummy lines DLI separated from the first connection lines CLI1 may be further disposed in the second area A2. In one or more embodiments, the first connection lines CLI1 and the dummy lines DLI may be disposed on or at the same layer (e.g., the first conductive layer) of the circuit unit PCL. In one or more embodiments, the dummy lines DLI disposed in the second area A2 may be lines of multiple layers, and may further include at least one conductive pattern disposed on another layer (e.g., the second conductive layer and/or the third conductive line layer of the circuit unit PCL).

The first connection lines CLI1 and the dummy lines DLI may have the same width or different widths. In one or more embodiments, the first connection lines CLI1 and the dummy lines DLI may have substantially the same width as shown in FIG. 16, and the respective dummy lines DLI corresponding to the respective first connection lines CLI1 may be positioned on a straight line in the second direction DR2. In one or more embodiments, the first connection lines CLI1 and the dummy lines DLI may have different widths as shown in FIG. 17, and different numbers of first connection lines CLI1 and dummy line(s) DLI may be disposed in each first line space LA1. For example, each dummy line DLI may have a width greater than that of each first connection line CLI1. In one or more embodiments, at least some of the dummy lines DLI disposed in the second area A2 may be connected to the power line PL.

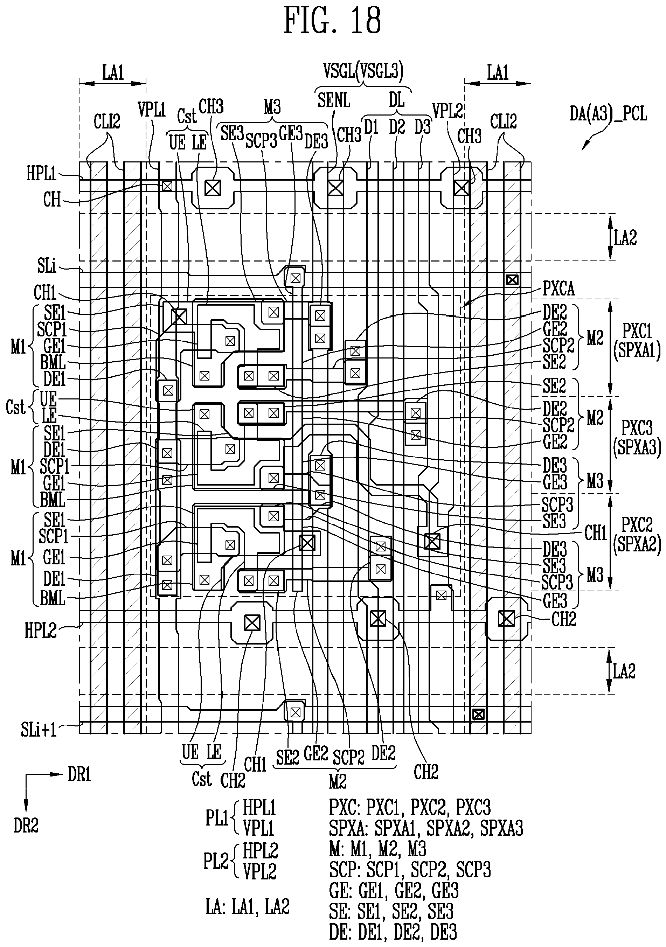

FIG. 18 is a plan view illustrating a circuit unit PCL of a third area A3 according to one or more embodiments of the present disclosure.

Referring to FIGS. 1 to 18, the second connection lines CLI2 may be disposed in the first line spaces LA1 of the third area A3. The second connection lines CLI2 may extend in the second direction DR2, and may be disposed on or at the same layer as the signal lines and/or the power lines PL extending in the second direction DR2. For example, the second connection lines CLI2 may be disposed on the first conductive layer of the circuit unit PCL together with the second signal lines VSGL, the first vertical power line VPL1, and the second vertical power line VPL2. In one or more embodiments, the second connection lines CLI2 may be lines of multiple layers, and may further include at least one conductive pattern disposed on another layer (e.g., the second conductive layer and/or the third conductive layer of the circuit unit PCL). The second connection lines CLI2 may be connected (e.g., electrically connected) to the first signal lines HSGL (e.g., the respective scan lines SL) through respective contact holes CH in the third area A3.

In one or more embodiments, in the first line spaces LA1 of the third area A3, the dummy lines DLI (e.g., the dummy lines DLI disposed in the third area A3 of FIG. 8) may be further disposed. For example, each of the second connection lines CLI2 may be disconnected after passing through each of the contact holes CH, and the dummy lines DLI separated from the second connection lines CLI2 may be further disposed in the third area A3.

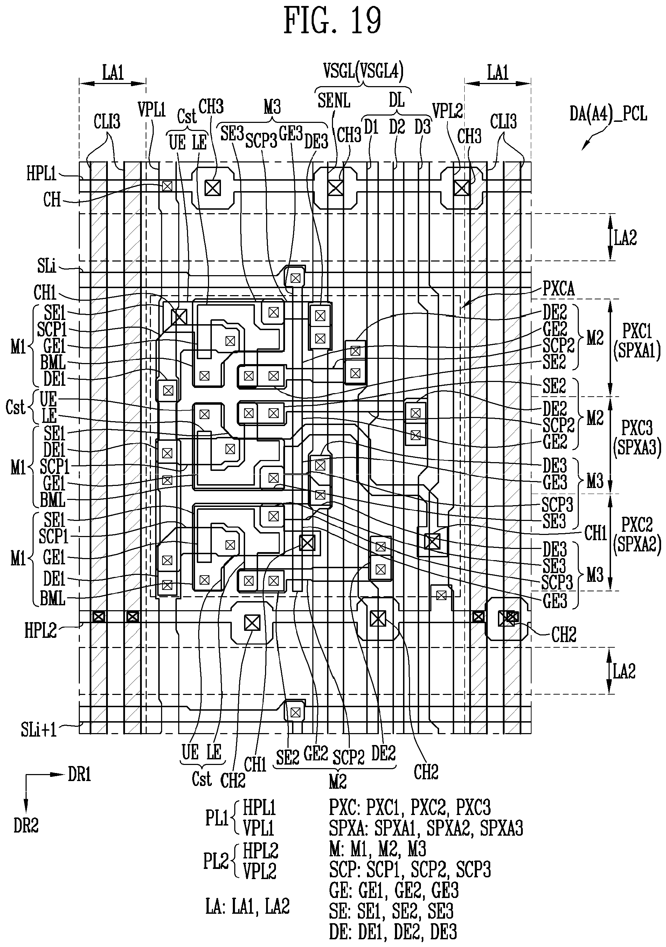

FIG. 19 is a plan view illustrating a circuit unit PCL of a fourth area A4 according to one or more embodiments of the present disclosure.

Referring to FIGS. 1 to 19, the third connection lines CLI3 may be disposed in the first line spaces LA1 of the fourth area A4. The third connection lines CLI3 may extend in the second direction DR2, and may be disposed on or at the same layer as the signal lines and/or the power lines PL extending in the second direction DR2. For example, the third connection lines CLI3 may be disposed on the first conductive layer of the circuit unit PCL together with the second signal lines VSGL, the first vertical power line VPL1, and the second vertical power line VPL2. In one or more embodiments, the third connection lines CLI3 may be lines of multiple layers, and may further include at least one conductive pattern disposed on another layer (e.g., the second conductive layer and/or the third conductive layer of the circuit unit PCL).

In one or more embodiments, the third connection lines CLI3 may be connected (e.g., electrically connected) to at least one power line PL (e.g., the second horizontal power line HPL2) through respective contact holes CH in the fourth area A4. In one or more embodiments, the third connection lines CLI3 may be integrally formed with at least one adjacent power line PL (e.g., the second vertical power line VPL2) in the fourth area A4.

In FIG. 19, an embodiment in which two or more third connection lines CLI3 are disposed in each of the first line spaces LA1 of the fourth area A4 is described, but embodiments of the present disclosure are not limited thereto. For example, a single third connection line CLI3 may be disposed in each of the first line spaces LA1 of the fourth area A4.

In one or more embodiments, the number of connection lines CLI and/or dummy lines DLI disposed in each of the first line spaces LA1 of the first area A1, the second area A2, the third area A3, and/or the fourth area A4 may be identical to each other or different from each other.

In accordance with the display device DD according to embodiments of the present disclosure, lines (e.g., the connection lines CLI and the second signal lines VSGL except for the second signal lines VSGL1 of the first area A1) connected between the display area DA and the pad area PA of the display panel DPN or each block BLK of the display panel DPN may be formed (e.g., uniformly formed) along the second direction DR2. In one or more embodiments, the second direction DR2 may be a direction corresponding to the shortest distance between the display area DA and the pad area PA. Accordingly, a length of the lines may be reduced or minimized, and the non-display area NA of the display device DD may be reduced or minimized.

In one or more embodiments, in the first direction DR1, the second signal lines VSGL1 of the first area A1 positioned at an edge of the display panel DPN or each block BLK of the display panel DPN may be connected to the first connection lines CLI1 provided in the second area A2 adjacent to the first area A1 to be connected (e.g., electrically connected) to each of the first pads P1. Accordingly, the pad-free area PFA corresponding to the first area A1 may be secured, and a distance between the driving circuits DIC (e.g., tap-ICs) may be sufficiently secured.

In one or more embodiments, the number of first connection lines CLI1 disposed in each second pixel column COL2 and/or the width of the pad-free area PFA may be adjusted by adjusting the number and/or the ratio thereof of the second pixel columns COL2 of the second area A2 allocated to the first pixel columns COL1 of the first area A1. Accordingly, according to various design conditions including a suitable distance (e.g., a minimum distance) to be secured between the line spaces LA and/or the driving circuits DIC that may be secured in the display area DA, a ratio (e.g., a ratio of a width and/or an area) of the first area A1 and the second area A2, the width of the pad-free area PFA, and/or the number, a disposition structure, and/or the like of additional lines (e.g., the connection lines CLI, the dummy lines DLI, and/or the additional power lines PL) formed in each pixel column COL may be appropriately and/or easily adjusted. In one or more embodiments, process efficiency may be increased by forming the additional lines in a process of forming each of the pixels PXL and lines connected thereto without adding a separate process for forming the additional lines.

As discussed, embodiments may provide a display device comprising: a display area including a first area, a second area, and a third area in a first direction; first signal lines in the display area and extending in the first direction; second signal lines in the display area and extending in a second direction; pixels in the display area and connected to the first signal lines and the second signal lines; a first pad area at one side (or end) of the second area in the second direction; first lines in the second area and connected from the second area to the first pad area; and bridges in the display area and connecting second signal lines in the first area from among the second signal lines to the first lines, wherein the first area includes first pixel columns comprising different second signal lines in the first area from among the second signal lines, wherein the second area includes second pixel columns comprising different second signal lines in the second area from among the second signal lines and different first lines from among the first lines, and wherein each of the second pixel columns comprises a number of the first lines corresponding to a ratio of a number of the first pixel columns to a number of the second pixel columns.

The "different second signal lines in the first area from among the second signal lines" may be a first group of second signal lines. The "different second signal lines in the second area from among the second signal lines" may be a second group of second signal lines. The "different first lines from among the first lines" may include a number of the first lines.

Each of the second pixel columns may include a number of first line(s) corresponding to a ratio of the number of first pixel columns disposed in the first area and the number of second pixel columns disposed in the second area. For example, in the second area, the number of the first connection lines (e.g., the same number as or a multiple of the number of second signal lines of the first area) corresponding to the number of the first lines suitable to connect the second signal lines of the first area to the respective first pads may be disposed, and the first lines may be divided and disposed in the second pixel columns. Accordingly, each of the second pixel columns may include the number of the first line allocated according to the ratio of the number of the first pixel columns and the number of the second pixel columns.

The display area may at least two first areas, second areas, and/or fourth areas. For example, the third area may be positioned at a center region of the display area based on the first direction. One first area, one second area, and/or one fourth area may be positioned on both sides of the third area. For example, a first area, a second area, and/or a fourth area may be on or at a first side of the third area and another first area, another second area, and/or another fourth area may be on or at a second side of the third area opposite to the first side.

The first area may be positioned at both edges (e.g., opposite edges) of the display area in the first direction. The second area may be positioned between the first area and the third area. For example, the second area may be an area directly adjacent to the first area in the first direction. A fourth area may be positioned between the first area and the third area. The first signal lines may be commonly formed in the first area, the second area, the third area, and the fourth area.

Pads may be arranged at one (or end) of the second area, third area and fourth area (if present).

The first signal lines may, for example, be scan lines.

The second signal lines may, for example, be data lines.

The second signal lines may include second signal lines of a first group positioned in the first area, second signal lines of a second group positioned in the second area, and second signal lines of a third group positioned in the third area. They may also include second signal lines of a fourth group positioned in the fourth area (if present).

The second signal lines of the first group may extend in the second direction in the first area and may be disposed in respective pixel columns positioned in the first area. The respective second signal lines of the first group may be connected (e.g., electrically connected) to the pixels disposed in the corresponding pixel columns of the first area.

The second signal lines of the first group may be connected (e.g., electrically connected) to the respective first connection lines positioned in the second area through the respective bridges.

The second signal lines of the second group, the second signal lines of the third group, and the second signal lines of the fourth group (if present) may extend in the second direction in the second area, the third area, and the fourth area (if present), respectively, and may be disposed in the respective pixel columns positioned in the second area, the third area, and the fourth area (if present).

The second signal lines of the second group, the second signal lines of the third group, and the second signal lines of the fourth group (if present) may be connected to the pad area from the second area, the third area, and the fourth area (if present), respectively, and may be connected (e.g., electrically connected) to the respective pads disposed in the pad area.

The first lines may be connection lines. The first lines in the second area may be first connection lines. Second lines may be provided as second connection lines. In one or more embodiments, the connection lines may further include at least one third line (or "third connection line"). For example, the connection lines may include one or more third connection line disposed in each of two fourth areas positioned on or at opposite sides of the third area.

The first lines ("first connection lines"), the second lines ("second connection lines"), and the third lines ("third connection lines") may extend in the second direction in the second area, the third area, and the fourth area, respectively, and may be disposed in the respective pixel columns positioned in the second area, the third area, and the fourth area. The first connection lines, the second connection lines, and the third connection lines may be connected from the display area to the pad area, and may be connected (e.g., electrically connected) to the respective pads disposed in the pad area.

For example, the first connection lines may extend in the second direction from the second area to be connected to the first pad area, and may be connected (e.g., electrically connected) to the respective first pads disposed in the first pad area.

The second connection lines may extend in the second direction from the third area to be connected to the second pad area, and may be connected (e.g., electrically connected) to the respective third pads disposed in the second pad area.

The third connection lines may extend in the second direction from the fourth area to be connected to the third pad area, and may be connected (e.g., electrically connected) to respective fifth pads disposed in the third pad area. Each third connection line may be connected (e.g., electrically connected) to any one power line (e.g., the first power line, the second power line, or another power line (e.g., the initialization power line, a ground power line, or a reference power line)) in the fourth area.

Embodiments may provide a display device comprising: a display panel comprising blocks arranged in a first direction; and driving circuits on pad areas of each of the blocks and arranged along the first direction, wherein each of the blocks comprises: a display area including a first area and a second area along the first direction, and comprising first signal lines extending in the first direction, second signal lines extending in a second direction, and pixels connected to the first signal lines and the second signal lines; a pad-free area and a pad area at one side of the first area and the second area in the second direction, respectively; first lines in the second area and connected from the second area to the pad area; and bridges connecting second signal lines in the first area from among the second signal lines to the first lines, wherein the first area includes first pixel columns comprising different second signal lines in the first area from among the second signal lines, wherein the second area includes second pixel columns comprising different second signal lines in the second area from among the second signal lines and different first lines from among the first lines, and wherein each of the second pixel columns comprises a number of the first lines corresponding to a ratio of a number of the first pixel columns to a number of the second pixel columns.

An effect according to embodiments is not limited by the contents exemplified above, and more various effects are included in the present specification.

In the above, the present disclosure is specifically described with reference to the above-described embodiments, but it should be noted that the above-described embodiments are for the purpose of description and not of limitation. In one or more embodiments, those skilled in the art may understand that various suitable modifications are possible.

The scope of the present disclosure is not limited to the details described in the detailed description of the specification, but should be defined by the claims. In one or more embodiments, it is to be construed that all changes or modifications derived from the meaning and scope of the claims and equivalent concepts thereof are included in the scope of the present disclosure.

## Claims

1. A display device comprising:
a display area including a first area, a second area, and a third area in a first direction;
first signal lines in the display area and extending in the first direction;
second signal lines in the display area and extending in a second direction;
pixels in the display area and connected to the first signal lines and the second signal lines;
a first pad area at one side of the second area in the second direction;
first lines in the second area and connected from the second area to the first pad area; and
bridges in the display area, the bridges connecting second signal lines in the first area from among the second signal lines to the first lines,
wherein the first area includes first pixel columns comprising different second signal lines in the first area from among the second signal lines,
wherein the second area includes second pixel columns comprising different second signal lines in the second area from among the second signal lines and different first lines from among the first lines, and
wherein each of the second pixel columns comprises a number of the first lines corresponding to a ratio of a number of the first pixel columns to a number of the second pixel columns.

2. The display device according to claim 1, wherein each of the second pixel columns comprises the first lines corresponding to a number proportional to a number of the first pixel columns and a number of the second signal lines in each of the first pixel columns.

3. The display device according to claim 2, wherein each of the second pixel columns comprises the number of the first lines inversely proportional to the number of the second pixel columns.

4. The display device according to any one of claims 1 to 3, wherein each of the second pixel columns comprises the same number of the first lines as a number of the second signal lines in each of the first pixel columns, and
wherein the second area comprises the same number of the second pixel columns as the number of the first pixel columns in the first area.

5. The display device according to any one of claims 1 to 4, wherein each of the second pixel columns comprises the number of the first lines corresponding to 1/K of a number of the second signal lines in each of the first pixel columns,
wherein K is a positive integer greater than or equal to 2, and
wherein the second area comprises the number of the second pixel columns corresponding to K times the number of the first pixel columns.

6. The display device according to any one of claims 1 to 4, wherein a ratio of a number of the second signal lines in each of the first pixel columns to a number of the first lines in each of the second pixel columns is N:M,
wherein each of N and M is a positive integer greater than or equal to 2, and
wherein a ratio of the number of the first pixel columns to the number of the second pixel columns is M:N.

7. The display device according to any one of claims 1 to 6, further comprising a pad-free area at one side of the first area in the second direction.

8. The display device according to any one of claims 1 to 7, further comprising:
first pads in the first pad area and electrically connected to the second signal lines in the first area through the first lines and the bridges; and
second pads in the first pad area and electrically connected to the second signal lines in the second area,
wherein the first lines extend in the second direction from the second area and are connected to the first pad area, and
wherein the second signal lines in the second area from among the second signal lines extend in the second direction from the second area and are connected to the first pad area.

9. The display device according to any one of claims 1 to 8, further comprising a second pad area at one side of the third area in the second direction,
wherein second signal lines in the third area from among the second signal lines extend in the second direction from the third area and are connected to the second pad area.

10. The display device according to claim 9, further comprising second lines in the third area, extending in the second direction from the third area, and connected to the second pad area;
third pads in the second pad area and electrically connected to the first signal lines through the second lines; and
fourth pads in the second pad area and electrically connected to the second signal lines in the third area;,
wherein the second lines are electrically connected to the first signal lines in the third area.

11. The display device according to any one of claims 1 to 10, further comprising:
a fourth area around the third area;
a third pad area at one side of the fourth area in the second direction;
a power line in the display area and connected to the pixels;
a third line in the fourth area, connected to the power line, extending in the second direction from the fourth area, and connected to the third pad area;
fifth pads in the third pad area and electrically connected to the power line through the third line;
sixth pads in the third pad area and electrically connected to second signal lines in the fourth area from among the second signal lines;
dummy line extending in the second direction and connected to the power line in the display area.

12. The display device according to any one of claims 1 to 11, wherein each of the first lines is between pixel circuits of pixels in second pixel columns adjacent to each other in the first direction from among the second pixel columns, or around pixel circuits of pixels in a first or last second pixel column of the second area.

13. The display device according to any one of claims 1 to 12, wherein the bridges are between two pixel rows adjacent to each other in the second direction.

14. The display device according to any one of claims 1 to 13, further comprising:
a pad area including the first pad area and a second pad area adjacent to the first pad area and at one side of the third area in the second direction; and
a pad-free area at both sides of the pad area in the first direction and at one side of the first area in the second direction,
wherein the first area is at both edges of the display area in the first direction,
wherein the second area is directly adjacent to the first area in the first direction, and
wherein the third area is at a center of the display area in the first direction.

15. A display device comprising:
a display panel comprising blocks arranged in a first direction; and
driving circuits on pad areas of each of the blocks and arranged along the first direction,
wherein each of the blocks comprises:
a display area including a first area and a second area along the first direction, and comprising first signal lines extending in the first direction, second signal lines extending in a second direction, and pixels connected to the first signal lines and the second signal lines;
a pad-free area and a pad area at one side of the first area and the second area in the second direction, respectively;
first lines in the second area and connected from the second area to the pad area; and
bridges connecting second signal lines in the first area from among the second signal lines to the first lines,
wherein the first area includes first pixel columns comprising different second signal lines in the first area from among the second signal lines,
wherein the second area includes second pixel columns comprising different second signal lines in the second area from among the second signal lines and different first lines from among the first lines, and
wherein each of the second pixel columns comprises a number of the first lines corresponding to a ratio of a number of the first pixel columns to a number of the second pixel columns.
